# EUROPEAN PATENT SPECIFICATION

(11) **EP 2 602 811 B1**
(45) Date of publication and mention of the grant of the patent: **08.11.2017**
(21) Application number: 10855620.0
(22) Date of filing: 04.08.2010
(51) Int. Cl.: H01L 21/027, B29C 59/02, C08F 220/28, G03F 7/004, G03F 7/027

(54) **PHOTOCURABLE COMPOSITION AND METHOD FOR PRODUCING MOLDED BODY HAVING SURFACE THAT IS PROVIDED WITH FINE PATTERN**
LICHTHÄRTBARE ZUSAMMENSETZUNG UND VERFAHREN ZUR HERSTELLUNG EINES FORMKÖRPERS MIT EINER FEIN STRUKTURIERTEN OBERFLÄCHE
COMPOSITION PHOTODURCISSABLE ET PROCÉDÉ POUR LA PRODUCTION D'UN CORPS MOULÉ AYANT UNE SURFACE QUI EST DOTÉE D'UN MOTIF FIN

(43) Date of publication of application: 12.06.2013
(73) Proprietor: Asahi Glass Company, Limited, Tokyo 100-8405 (JP)
(72) Inventor: FUJIE, Ayako, Kanagawa 253-8585 (JP); KAWAGUCHI, Yasuhide, Tokyo 100-8405 (JP); NAKAYAMA, Fumiko, Tokyo 100-8405 (JP)
(74) Representative: Müller-Boré & Partner Patentanwälte PartG mbB
(86) International application number: PCT/JP2010/063211
(87) International publication number: WO 2012/017530

(56) References cited:
- EP-A1- 2 159 236
- WO-A1-2006/114958
- WO-A1-2010/050614
- JP-A- 2001 106 710
- JP-A- 2002 012 796
- JP-A- 2004 071 934
- JP-A- 2004 523 906
- JP-A- 2006 114 882
- JP-A- 2006 182 880
- JP-B- 3 985 821

## Description

### TECHNICAL FIELD

The present invention relates to a photocurable composition and a process for producing a molded product having a fine pattern on its surface.

### BACKGROUND ART

In the production of optical components, recording media, semiconductor devices, etc., as a method for forming a fine pattern in a short time, a method for forming a fine pattern on a surface of a substrate (nanoimprint method) is known wherein a mold having on its surface a reverse pattern of such a fine pattern, is pressed to a photocurable composition placed on the surface of a substrate, and the photocurable composition is irradiated with light to cure the photocurable composition thereby to form a fine pattern on the surface of the substrate (Patent Documents 1 and 2).

However, in such a method, the cured product of the photocurable composition adheres to the mold, whereby it is difficult to separate the cured product from the mold. Therefore, it is necessary to apply a release agent to the surface of the mold. However, it becomes difficult to precisely transfer the reverse pattern of the mold due to the film thickness of the release agent itself, uneven application of the release agent, etc.

As a photocurable composition capable of forming a cured product having a good release property, the following have been proposed.
(1) An active energy ray-curable composition comprising a fluorinated surfactant having a fluorinated alkyl group and a polar group in its molecule (Patent Document 3).
(2) A photocurable composition comprising a fluorinated monomer, a monomer containing no fluorine, a fluorinated surfactant or fluorinated polymer, and a photopolymerization initiator (Patent Document 4).

However, the photocurable compositions (1) and (2) have the following problems.
(i) A fluorinated surfactant is made of a compound derived from perfluorooctanesulfonic acid as the material to improve the release property, or it contains a very small amount of such a compound in many cases. The compound derived from perfluorooctanesulfonic acid has been pointed out as being environmentally persistent and bioaccumulative, an its use tends to be restricted.
(ii) In a case where the fluorinated surfactant has a poly(oxyethylene) structure of terminal methyl groups and a case where the mold is a mold having a complicated fine pattern, a mold having a dense fine pattern, or a mold having a large area of the fine pattern region, or the like, the release property of the cured product of the photocurable composition from the mold may be insufficient, or the fine pattern of the mold may not sufficiently be filled with the photocurable composition.
(iii) In a case where the molecular weight or the composition of the fluorinated surfactant is not controlled, the composition of the surface of the cured product tends to be non-uniform, and the surface state of the cured product may be dispersed, and accordingly the weather resistance may be decreased when the cured product is used as a permanent film, the etching rate may be dispersed in the plane when it is used as a resist, or a part of an object to be transferred adheres when it is used as a replica mold.

### PRIOR ART DOCUMENTS

### PATENT DOCUMENTS

Patent Document 1: U.S. Patent No. 6696220
Patent Document 2: JP-A-2004-071934
Patent Document 3: JP-A-2001-106710
Patent Document 4: WO2006/114958

### DISCLOSURE OF INVENTION

### TECHNICAL PROBLEM

The present invention provides a photocurable composition with which a cured product having an excellent release property can be formed without using a fluorinated surfactant made of a compound derived from perfluorooctanesulfonic acid as a material, and which exhibits excellent compatibility between a fluorinated surfactant and other components, and a process for producing a molded product having on its surface a fine pattern having a reverse pattern of a mold precisely transferred, and having a uniform composition of the surface.

### SOLUTION TO PROBLEM

The photocurable composition for imprint of the present invention is the following photocurable composition for imprint.

A photocurable composition for imprint, containing, as the main component, a compound (hereinafter sometimes referred to as compound (X)) having at least one acryloyloxy group or methacryloyloxy group, and further comprises a polymer (D) which is a copolymer of the following compound (A), the following compound (B) and the following compound (C) in a proportion of units of the compound (A) of from 20 to 45 mass%, a proportion of units of the compound (B) of from 20 to 65 mass% and a proportion of units of the compound (C) of from 5 to 40 mass%, to the total amount of the units of the compound (A), the units of the compound (B) and the units of the compound (C), and which has a mass average molecular weight of from 1,000 to 5,000:
compound (A): a compound represented by the following formula (1):

   CH₂=C(R¹¹)-C(O)O-Q-R^{f} (1)

   wherein R¹¹ is a hydrogen atom or a methyl group, Q is a single bond or a bivalent linking group containing no fluorine atom, and R^{f} is a polyfluoroalkyl group with a main chain having from 1 to 6 carbon atoms, which may have an etheric oxygen atom between carbon atoms;
compound (B): a compound represented by the following formula (2), which has a number average molecular weight of at most 350:

   CH₂=C(R²¹)-C(O)O-(CH₂CH(R²²)O)ₙ-H (2)

   wherein R²¹ is a hydrogen atom or a methyl group, R²² is a hydrogen atom or a C₁₋₄ alkyl group, and n is from 3 to 6, provided that R²²'s in one molecule may be the same or different from one another;
compound (C): a compound represented by the following formula (3):

   CH₂=C(R³¹)-C(O)O-R³² (3)

   wherein R³¹ is a hydrogen atom or a methyl group, and R³² is a C₂₋₁₅ monovalent aliphatic hydrocarbon group.

The photocurable composition for imprint of the present invention is a composition containing the compound (X) as the main component and usually contains a photopolymerization initiator (G). Further, the compound (X) is at least one member selected from the group consisting of a compound (hereinafter sometimes referred to as compound (Y)) having one acryloyloxy group or methacryloyloxy group and a compound (H) having at least two acryloyloxy groups or methacryloyloxy groups.

In the present invention, the compound (Y) is classified into two types i.e. a compound (E) having fluorine atoms and a compound (F) having no fluorine atom. In a case where the photocurable composition of the present invention contains the compound (Y), the compound (Y) is at least one member selected from the group consisting of the compound (E) and the compound (F). The photocurable composition of the present invention preferably contains the compound (Y). That is, as at least part of the compound (X), at least one member selected from the group consisting of the compound (E) and the compound (F) is preferably contained. More preferably, both the compound (E) and the compound (F) are contained.

Further, the photocurable composition of the present invention preferably contains the compound (H).

In the photocurable composition of the present invention, the proportion of the polymer (D) is preferably from 0.01 to 5 mass% to the photocurable composition. Further, the proportion of the photopolymerization initiator (G) is preferably from 1 to 12 mass% to the photocurable composition.

The photocurable composition of the present invention comprises at least any one of the above compound (E), compound (F) and compound (H), preferably in the following proportions of the respective compounds to the photocurable composition:
Compound (E): from 5 to 40 mass%,
Compound (F): from 10 to 55 mass%,
Compound (H): from 10 to 75 mass%.

In the present invention, the photocurable composition means a composition containing no solvent. The composition to be photo-cured is a composition containing substantially no solvent. However, the composition before being cured may contain a solvent. That is, the photocurable composition for imprint of the present invention may be operated before curing in a solution state containing a solvent, for the purpose of coating or the like. The proportions of the respective components mean the proportions of the respective components based on the photocurable composition containing no solvent (or, in the case of a composition containing a solvent, the total amount of the components excluding the solvent). Further, in the same sense, the viscosity of the photocurable composition for imprint of the present invention at 25°C is preferably from 3 to 200 mPa·s.

The present invention provides a process for producing a molded product having a fine pattern on its surface, which comprises a step of bringing the photocurable composition for imprint of the present invention into contact with a reverse pattern surface of a mold having the reverse pattern of said fine pattern on said surface, a step of irradiating the photocurable composition with light in such a state that the photocurable composition is in contact with the surface of the mold, to cure the photocurable composition to form a cured product, and a step of separating the mold from the cured product to obtain a molded product having a fine pattern on its surface.

The present invention provides a process for producing a molded product having a fine pattern on its surface, which comprises a step of placing the photocurable composition for imprint of the present invention on a surface of a substrate, a step of pressing a mold having a reverse pattern of said fine pattern on its surface against the photocurable composition so that the reverse pattern of the mold is in contact with the photocurable composition, a step of irradiating the photocurable composition with light in such a state that the mold is pressed against the photocurable composition, to cure the photocurable composition to form a cured product, and a step of separating the mold, or the substrate and the mold, from the cured product to obtain a molded product having a fine pattern on its surface.

The present invention provides a process for producing a molded product having a fine pattern on its surface, which comprises a step of placing the photocurable composition for imprint of the present invention on a reverse pattern surface of a mold having the reverse pattern of said fine pattern on said surface, a step of pressing a substrate against the photocurable composition, a step of irradiating the photocurable composition with light in such a state that the substrate is pressed against the photocurable composition, to cure the photocurable composition to form a cured product, and a step of separating the mold, or the substrate and the mold, from the cured product to obtain a molded product having a fine pattern on its surface.

The present invention provides a process for producing a molded product having a fine pattern on its surface, which comprises a step of bringing a substrate and a mold having a reverse pattern of said fine pattern on its surface close to or in contact with each other so that the reverse pattern of the mold is on the substrate side, a step of filling the space between the substrate and the mold with the photocurable composition for imprint of the present invention, a step of irradiating the photocurable composition with light in such a state that the substrate and the mold are close to or in contact with each other, to cure the photocurable composition to form a cured product, and a step of separating the mold, or the substrate and the mold, from the cured product to obtain a molded product having a fine pattern on its surface.

The fine pattern may be a resist pattern, and the molded product having a fine pattern on its surface may be a replica mold for imprint or a replica mode for electroforming.

### ADVANTAGEOUS EFFECTS OF INVENTION

By the photocurable composition of the present invention, a cured product having an excellent release property can be formed without using a fluorinated surfactant made of a compound derived from perfluorooctanesulfonic acid as a material, and excellent compatibility between a fluorinated surfactant and other components will be obtained.

By each process for producing a molded product having a fine pattern on its surface according to the present invention, it is possible to produce a molded product having on its surface a fine pattern having a reverse pattern of a mold precisely transferred, and having a uniform composition of the surface.

### BRIEF DESCRIPTION OF DRAWINGS

Fig. 1 is a cross-sectional view illustrating an embodiment of the process for producing a molded product having a fine pattern on its surface.
Fig. 2 is a cross-sectional view illustrating another embodiment of the process for producing a molded product having a fine pattern on its surface.
Fig. 3 is a cross-sectional view illustrating an embodiment of the molded product having a fine pattern on its surface.
Fig. 4 is a cross-sectional view illustrating another embodiment of the molded product having a fine pattern on its surface.

### DESCRIPTION OF EMBODIMENTS

In the present specification, a (meth)acryloyloxy group means an acryloyloxy group or a methacryloyloxy group. Further, in the present specification, a (meth)acrylate means an acrylate or a methacrylate.

### <Photocurable composition>

The photocurable composition for imprint of the present invention (hereinafter referred to as photocurable composition) is a composition containing, as the main component, a compound having at least one acryloyloxy group or methacryloyloxy group (i.e. compound (X)), and usually contains a photopolymerization initiator (G) to impart photocuring property. Further, the photocurable composition of the present invention comprises a polymer (D) as an essential component. Further, it may contain another component such as the after-mentioned additive (I) as the case requires. As mentioned above, the photocurable composition of the present invention means a composition containing no solvent. However, at the time of photocuring, a solution containing a solvent which is not substantially contained in the composition (i.e. a solution of the photocurable composition) may be used for production of the molded product.

The compound (X) is a compound having at least one (meth)acryloyloxy group, and in the present invention, it is classified into a compound having one (meth)acryloyloxy group (i.e. compound (Y)) and a compound having at least two (meth)acryloyloxy groups (i.e. compound (H)). The compound (Y) is classified into the compound (E) and the compound (F).

The compound (X) is preferably a compound having an acryloyloxy group in view of easy photopolymerization. That is, the compound (E) and the compound (F) are more preferably compounds having one acryloyloxy group, and the compound (H) is more preferably a compound in which all the (meth)acryloyloxy groups are acryloyloxy groups.

In the photocurable composition (composition containing no solvent) of the present invention, the compound (X) is the essential and main component. The photocurable composition of the present invention contains at least one member selected from the group consisting of the compound (E), the compound (F) and the compound (H), and these components in total constitute the main component (component exceeding 50 mass%) of the photocurable composition. In the photocurable composition of the present invention, the proportion of the compound (X) is preferably at least 60 mass%, more preferably at least 80 mass% to the photocurable composition (composition containing no solvent).

The compound (X) contained in the photocurable composition of the present invention may be only one member selected from the compound (E), the compound (F) and the compound (H), and in such a case, the compound (X) is preferably the compound (H). The compound (X) contained in the photocurable composition is more preferably at least either of the compound (E) and the compound (F), and the compound (H). Most preferably, the compound (X) comprises the compound (E), the compound (F) and the compound (H). The photocurable composition of the present invention may contain a photopolymerizable compound other than the compound (X) as the case requires.

The viscosity of the photocurable composition (composition containing no solvent) of the present invention at 25°C is preferably from 3 to 200 mPa·s, more preferably from 5 to 100 mPa·s. When the viscosity of the photocurable composition is within such a range, the photocurable composition and the surface having a reverse pattern of a mold can be easily brought into contact with each other without any special operation (such as an operation of heating the photocurable composition to high temperature to make it have a low viscosity).

The photocurable composition of the present invention is a composition containing substantially no solvent at the time of curing, and is preferably a composition containing substantially no solvent at the time of handling the photocurable composition, e.g. at the time of coating, before curing. When the photocurable composition contains substantially no solvent, curing of the photocurable composition can easily be conducted without any specific operation (such as an operation of heating the photocurable composition to high temperature to remove the solvent) except for irradiation with light.

The solvent is a compound having a property to dissolve any of the polymer (D), the compound (E), the compound (F), the photopolymerization initiator (G), the compound (H) and the additive therein, and is a compound having a boiling point under normal pressure of at most 160°C.

The photocurable composition containing substantially no solvent means that the amount of the solvent contained in the photocurable composition is at most 1 mass% to the photocurable composition. In the present invention, the solvent used when the photocurable composition is prepared may be contained as the remaining solvent, however, the remaining solvent is preferably removed as far as possible, and the content of the solvent such as the remaining solvent is more preferably at most 0.7 mass% to the photocurable composition.

### <<Polymer (D)>>

The polymer (D) is a copolymer of the compound (A), the compound (B) and the compound (C) in a proportion of units of the compound (A) of from 20 to 45 mass%, a proportion of units of the compound (B) of from 20 to 65 mass% and a proportion of units of the compound (C) of from 5 to 40 mass%, to the total amount of the units of the compound (A), the units of the compound (B) and the units of the compound (C), and is a polymer having a mass average molecular weight of from 1,000 to 5,000.

Compound (A): A compound represented by the following formula (1):

CH₂=C(R¹¹)-C(O)O-Q-R^{f} (1)

R¹¹ is a hydrogen atom or a methyl group.
Q is a single bond or a bivalent linking group containing no fluorine atom. The bivalent linking group may be a C₁₋₁₀ linear or branched alkylene group, a C₂₋₁₀ linear or branched alkenylene group, an oxyalkylene group represented by the formula (CᵣH₂ᵣO)ₛ (wherein r is an integer of from 2 to 6, s is a number of from 1 to 10, and the oxyalkylene group may have a linear structure or a branched structure), a bivalent 6-membered aromatic group, a bivalent 4- to 6-membered saturated or unsaturated aliphatic group, a bivalent 5- to 6-membered heterocyclic group or a bivalent linking group represented by the following formula (4). The bivalent linking group may be a combination of at least two, may be one having rings condensed, or may have a substituent. Q is preferably a linking group having a total atomic weight of at most 300.

   -Y-Z- (4)

   wherein Y is a C₁₋₁₀ linear or branched alkylene group, a bivalent 6-membered aromatic group, a bivalent 4- to 6-membered saturated or unsaturated aliphatic group, a bivalent 5- to 6-membered heterocyclic group, or a cyclic group having these groups condensed, Z is -O-, -S-, -CO-, -C(O)O-, -C(O)S-, -N(R)-, -SO₂-, -PO(OR)-, -N(R)-C(O)O-, -N(R)-C(O)-, -N(R)-SO₂- or -N(R)-PO(OR)-, and R is a hydrogen atom or a C₁₋₃ alkyl group.
Q is preferably a single bond, a C₁₋₁₀ linear or branched alkylene group, a group represented by the following formula (5) or a combination of these groups, particularly preferably -(CH₂)ₚ- (wherein p is an integer of from 0 to 6, and this is a single bond when p is 0).

   -Y¹-Z¹- (5)

   wherein Y¹ is a C₁₋₁₀ linear or branched alkylene group, or a bivalent 6-membered aromatic group, Z¹ is -N(R)-, -SO₂- or -N(R)-SO₂-, and R is a hydrogen atom or a C₁₋₃ alkyl group.
R^{f} is a polyfluoroalkyl group which has a main chain having from 1 to 6 carbon atoms, which may have an etheric oxygen atom between carbon atoms. The boundary between Q and R^{f} is defined so that the number of carbon atoms in R^{f} is smallest.

The polyfluoroalkyl group means a group having at least two hydrogen atoms of an alkyl group with a main chain having from 1 to 6 carbon atoms (carbon atoms of side chains not included) substituted by fluorine atoms. Further, the main chain means, in the case of a linear structure, the linear chain, and in the case of a branched structure, the longest carbon chain. A side chain means a carbon chain other than the main chain, among carbon chains constituting the branched polyfluoroalkyl group. The side chain comprises an alkyl group, a monofluoroalkyl group or a polyfluoroalkyl group.

The polyfluoroalkyl group may be a partially fluoro-substituted alkyl group or a perfluoro-substituted alkyl group corresponding to a linear or branched alkyl group (methyl group, ethyl group, propyl group, butyl group, pentyl group or hexyl group).

The polyfluoroalkyl group having an etheric oxygen atom between carbon atoms is preferably a polyfluoro(alkoxyalkyl) group or a polyfluoro(polyoxyalkylene alkyl ether) group, such as a polyfluoro(2-ethoxyethyl) group, a polyfluoro(2-methoxypropyl) group, a polyfluoro(polyoxyethylene methyl ether) group or a polyfluoro(polyoxypropylene methyl ether) group.

R^{f} is preferably linear. In a case where R^{f} is branched, the branched moiety is present preferably at a portion as close to the terminal of R^{f} as possible.

R^{f} is preferably a polyfluoroalkyl group, more preferably a perfluoroalkyl group having substantially all hydrogen atoms substituted by fluorine atoms, further preferably a linear perfluoroalkyl group, and in view of low environmental persistence and bioaccumulative properties and a high release property, particularly preferably a C₄₋₆ linear perfluoroalkyl group, most preferably a C₆ linear perfluoroalkyl group.

The compound (A) is preferably a compound (A-1) represented by the following formula (6):

CH₂=C(R¹¹)-C(O)O-(CH₂)ₚ-R^{F} (6)

wherein R¹¹ is a hydrogen atom or a methyl group, p is an integer of from 0 to 6, and R^{F} is a C₁₋₆ linear perfluoroalkyl group.

As specific examples of the compound (A-1), the following compounds may be mentioned.

CH₂=CH-C(O)O-(CH₂)₂-(CF₂)₆F,

CH₂=CH-C(O)O-(CH₂)₂-(CF₂)₄,

CH₂=CH-C(O)O-(CH₂)₂-(CF₂)₂F,

CH₂=CH-C(O)O-(CH₂)₂-CF₃,

CH₂=C(CH₃)-C(O)O-(CH₂)₂-(CF₂)₆F,

CH₂=C(CH₃)-C(O)O-(CH₂)₂-(CF₂)₄F,

CH₂=C(CH₃)-C(O)O-(CH₂)₂-(CF₂)₂F,

CH₂=CH-C(O)O-CH₂-(CF₂)₂F,

CH₂=CH-C(O)O-CH₂-CF₃

and the like.

The compounds (A) may be used alone or in combination of at least two. That is, the polymer (D) may have at least two types of units of the compound (A).

The proportion of the units of the compound (A) in the polymer (D) is from 20 to 45 mass% to the total amount of the units of the compounds (A) to (C). When the proportion of the units of the compound (A) is at least 20 mass%, a cured product of the photocurable composition will have a good release property. When the proportion of the units of the compound (A) is at most 45 mass%, the polymer (D) and other components will be uniformly compatible.

### (Compound (B))

The compound (B) is a compound represented by the following formula (2), which has a number average molecular weight of at most 350.

CH₂=C(R²¹)-C(O)O-(CH₂CH(R²²)O)ₙ-H (2)

R²¹ is a hydrogen atom or a methyl group.
R²² is a hydrogen atom or a C₁₋₄ alkyl group.
R²²'s in one molecule may be the same or different from one another.
n means the number of moles of an alkylene oxide added when the compound (B) is produced, and is represented by the average value. n is from 3 to 6, preferably from 3.5 to 5.5. When n is within such a range, the polymer (D) and other components will be uniformly compatible.

The number average molecular weight of the compound (B) is at most 350, preferably at most 300. When the number average molecular weight of the compound (B) is at most 350, the polymer (D) and other component will be uniformly compatible. The number average molecular weight of the compound (B) is determined by calculation based on n (average value).

By the compound (B) having a hydroxy group, the fluorine components in the photocurable composition tend to face the surface, whereby a cured product of the composition will have a favorable release property. Specifically, as the compound (B) has a hydroxy group which is a polar group, polarity is imparted to the polymer (D). Therefore, the polymer (D) becomes amphipathic, and is easily mixed with the respective components in the photocurable composition. Accordingly, it is considered that components containing fluorine are likely to be exposed to the surface accompanying exposure of the fluoroalkyl group derived from the units of the compound (A) to the surface, whereby a cured product of the composition will have a favorable release property.

As specific examples of the compound (B), the following compounds may be mentioned.

CH₂=C(CH₃)-C(O)O-(CH₂CH₂O)ₙ-H,

CH₂=CH-C(O)O-(CH₂CH₂O)ₙ-H,

CH₂=C(CH₃)-C(O)O-(CH₂CH(CH₃)O)ₙ-H,

CH₂=CH-C(O)O-(CH₂CH(CH₃)O)ₙ-H,

CH₂=C(CH₃)-C(O)O-(CH₂CH₂O)ₙ₁-(CH₂CH(CH₃)O)ₙ₂-H,

CH₂=CH-C(O)O-(CH₂CH₂O)ₙ₁-(CH₂CH(CH₃)O)ₙ₂-H

and the like. In the above formulae, n is from 3 to 6, and n1+n2 is from 3 to 6.

The compound (B) may be used alone or in combination of at least two. That is, the polymer (D) may have at least two types of the units of the compound (B).

The proportion of the units of the compound (B) in the polymer (D) is from 20 to 65 mass% to the total amount of the units of the compounds (A) to (C). When the proportion of the units of the compound (B) is at least 20 mass%, the polymer (D) and other components will be uniformly compatible. When the proportion of the compound (B) is at most 65 mass%, a cured product of the photocurable composition will have a favorable release property.

### (Compound (C))

The compound (C) is a compound represented by the following formula (3):

CH₂=C(R³¹)-C(O)O-R³² (3)

R³¹ is a hydrogen atom or a methyl group.
R³² is a C₂₋₁₅ monovalent aliphatic hydrocarbon group. When the number of carbon atoms in the monovalent aliphatic hydrocarbon group is within such a range, the polymer (D) and other components will be uniformly compatible. The monovalent aliphatic hydrocarbon group may be an alkyl group, an alkenyl group or an alkynyl group. The aliphatic hydrocarbon group may be linear, branched or cyclic.
R³² is preferably an alkyl group, more preferably a C₄₋₁₂ alkyl group.

As specific examples of the compound (C), the following compounds may be mentioned.

CH₂=C(CH₃)-C(O)O-C₄H₉,

CH₂=C(CH₃)-C(O)O-CH₂CH(CH₃)₂,

CH₂=C(CH₃)-C(O)O-C₆H₁₃,

CH₂=C(CH₃)-C(O)O-Cy,

CH₂=C(CH₃)-C(O)O-CH(CH₃)C₂H₅,

CH₂=C(CH₃)-C(O)O-CH₂CH(C₂H₅)C₄H₉,

CH₂=C(CH₃)-C(O)O-C₁₂H₂₅,

CH₂=CH-C(O)O-C₄H₉,

CH₂=CH-C(O)O-CH₂CH(CH₃)₂,

CH₂=CH-C(O)O-C₆H₁₃,

CH₂=CH-C(O)O-Cy,

CH₂=CH-C(O)O-CH(CH₃)C₂H₅,

CH₂=CH-C(O)O-CH₂CH(C₂H₅)C₄H₉,

CH₂=CH-C(O)O-C₁₂H₂₅

and the like.

In the above formulae, Cy is a cyclohexyl group.

The compounds (C) may be used alone or in combination of at least two. That is, the polymer (D) may have at least two types of the units of the compound (C).

The proportion of the units of the compound (C) in the polymer (D) is from 5 to 40 mass% to the total amount of the units of the compounds (A) to (C). When the proportion of the units of the compound (C) is within such a range, a cured product of the photocurable composition will have a favorable release property.

### (Fourth component)

When the compounds (A) to (C) are polymerized, a fourth component copolymerizable with the compounds (A) to (C) may be added.

The fourth component may be a compound having at least one carbon-carbon unsaturated double bond (excluding the compounds (A) to (C)), and specifically, it may, for example, be a silicone group-containing (meth)acrylate, maleic anhydride or a phosphate group-containing (meth)acrylate.

The fourth components may be used alone or in combination of at least two.

The proportion of units of the fourth component (in a case where a plural types of units of the fourth component are present, their total amount) in the polymer (D) is preferably at most 20 mass% to the total amount of the units of the compounds (A) to (C) and the units of the fourth component (i.e. all the units in the polymer (D)). If the proportion of the units of the fourth component exceeds 20 mass%, the release property of a cured product of the photocurable composition may be lowered in some cases.

### (Polymer (D))

The polymer (D) is one obtainable by copolymerizing the compound (A), the compound (B) and the compound (C) and as the case requires, the fourth component.

By the photocurable composition of the present invention containing the polymer (D) as a nonionic fluorinated surfactant, the release property which is important for imprint can be improved.

The mass average molecular weight of the polymer (D) is from 1,000 to 5,000. When the mass average molecular weight of the polymer (D) is at least 1,000, a cured product of the photocurable composition will have a favorable release property. When the mass average molecular weight of the polymer (D) is at most 5,000, the polymer (D) and other components will be uniformly compatible, and the composition of the surface of the cured product will be uniform. The mass average molecular weight of the polymer (D) is preferably from 2,500 to 5,000.

The polymerization manner may, for example, be random polymerization, block polymerization or graft polymerization, and is preferably random polymerization.

The type of the polymerization may, for example, be radical polymerization, anionic polymerization or cationic polymerization.

The polymerization method is preferably a solution polymerization method of copolymerizing the compound (A), the compound (B) and the compound (C) in a solvent in the presence of a polymerization initiator.

The solvent may be any solvent in which the polymerization initiator and the compounds (A) to (C) are dissolved, and it may, for example, be water, an organic solvent or a fluorinated solvent, and in view of solubility, it is preferably an organic solvent. The organic solvent may, for example, be acetone, methanol, ethanol, 2-propanol, tert-butanol, ethyl acetate, methyl acetate, butyl acetate, toluene or tetrahydrofuran.

The polymerization initiator may, for example, be a peroxide or an azo compound.

The polymerization temperature is preferably from 0 to 150°C in view of easiness of control, and more preferably from 30 to 90°C in view of the correlation with the activation energy for decomposition of the polymerization initiator.

The polymer (D) may be used alone or in combination of at least two. That is, the photocurable composition may contain at least two types of the polymer (D).

The proportion of the polymer (D) is preferably from 0.01 to 5 mass%, more preferably from 0.1 to 2 mass% to the photocurable composition (composition containing the polymer (D)). When the proportion of the polymer (D) is at least 0.01 mass%, a cured product of the photocurable composition will have a favorable release property. When the proportion of the polymer (D) is at most 5 mass%, the polymer (D) and other components will be uniformly compatible, and the composition of the surface of the cured product will be uniform.

### <<Compound (X)>>

The compound (X) is a compound having at least one (meth)acryloyloxy group, and in the present invention, it is classified into a compound having one (meth)acryloyloxy group (i.e. compound (Y)) and a compound having at least two (meth)acryloyloxy groups (i.e. compound (H)). The compound (Y) is classified into the compound (E) and the compound (F).

The compound (X) is more preferably a compound having an acryloyloxy group in view of easy photopolymerization. That is, the compound (E) and the compound (F) are more preferably a compound having one acryloyloxy group, and the compound (H) is more preferably one in which all the (meth)acryloyloxy groups are acryloyloxy groups.

### (Compound (E))

The compound (E) is a compound having fluorine atoms and having one (meth)acryloyloxy group. When the photocurable composition of the present invention comprises the compound (E), a cured product of the photocurable composition will easily be released from the mold.

The compound (E) is preferably the compound (A) represented by the above formula (1). In the chemical formula, R¹¹ may be a fluorine atom. Further, in view of the compatibility and the environmental properties, the compound (E) is more preferably the compound (A-1) represented by the above formula (6), wherein R¹¹ is a hydrogen atom.

As the compound (E), in addition to the compounds mentioned as specific examples of the compound (A-1), the following compounds may be mentioned.

CH₂=CH-C(O)O-CH₂CH(OH)CH₂-CF₂CF₂CF(CF₃)₂,

CH₂=CH-C(O)O-CH(CF₃)₂,

CH₂=CH-C(O)O-CH₂-(CF₂)₆F,

CH₂=C(CH₃)-C(O)O-CH₂-(CF₂)₆F,

CH₂=CH-C(O)O-CH₂-CF₂CF₂H,

CH₂=CH-C(O)O-CH₂-(CF_{Z}CF₂)₂H,

CH₂=C(CH₃)-C(O)O-CH₂-CF₂CF₂H,

CH₂=C(CH₃)-C(O)O-CH₂-(CF₂CF₂)₂H,

CH₂=CH-C(O)O-CH₂-CF₂OCF₂CF₂OCF₃,

CH₂=CH-C(O)O-CH₂-CF₂O(CF₂CF₂O)₃CF₃,

CH₂=C(CH₃)-C(O)O-CH₂-CF₂OCF₂CF₂OCF₃,

CH₂=C(CH₃)-C(O)O-CH₂-CF₂O(CF₂CF₂O)₃CF₃,

CH₂=CH-C(O)O-CH₂-CF(CF₃)OCF₂CF(CF₃)O(CF₂)₃F,

CH₂=CH-C(O)O-CH₂-CF(CF₃)O(CF₂CF(CF₃)O)₂(CF₂)₃F,

CH₂=C(CH₃)-C(O)O-CH₂-CF(CF₃)OCF₂CF(CF₃)O(CF₂)₃F,

and

CH₂=C(CH₃)-C(O)O-CH₂-CF(CF₃)O(CF₂CF(CF₃)O)₂(CF₂)₃F.

The photocurable composition of the present invention preferably contains the compound (E). In such a case, one type or at least two types of the compound (E) may be contained in the photocurable composition. In a case where the photocurable composition contains the compound (E), the proportion of the composition (E) is preferably from 5 to 40 mass%, more preferably from 10 to 25 mass% to the photocurable composition (composition containing the compound (E)). When the proportion of the compound (E) is at least 5 mass%, a cured product excellent in the release property will be obtained, and foaming of the photocurable composition will be suppressed. As foaming of the photocurable composition can be suppressed, filtration is easily carried out at the time of preparation, and further, defects in the pattern shape due to inclusion of bubbles at the time of nanoimprint can be reduced. When the proportion of the compound (E) is at most 40 mass%, as uniform mixing is possible, a cured product excellent in the mechanical strength will be obtained.

Further, by employing the compound (E), the transparency of a cured product can be made high. Further, as the compound (E) contributes to a decrease in the viscosity and a decrease in the surface energy of the photocurable composition, it is useful to improve the resolution and to reduce the residual layer, when a cured product is to be used as a resist.

### (Compound (F))

The compound (F) is a compound having one (meth)acryloyloxy group (excluding the compound (E)).

The compound (F) is a component to dissolve the other components therein, and in a case where the photocurable composition of the present invention contains the compound (F), it improves the compatibility of the polymer (D) with the compound (E) and the compound (H). When the compatibility of the polymer (D) with the compound (E) and the compound (H) is favorable, foaming of the photocurable composition at the time of preparation can be suppressed, the photocurable composition is likely to pass through a filter, and so on, whereby preparation of the photocurable composition will be easy, and a uniform photocurable composition will be obtained. Further, as a homogenous cured product will be obtained, sufficient release property and mechanical strength will be obtained.

The viscosity of the compound (F) at 25°C is preferably from 0.1 to 200 mPa·s. When the viscosity of the compound (F) is within such a range, the viscosity of the photocurable composition will easily be adjusted to be low. Further, such is useful to improve the resolution and to reduce the residual layer, when a cured product is to be used as a resist.

The compound (F) may, for example, be a (meth)acrylate of a monohydroxy compound or a mono(meth)acrylate of a polyhydroxy compound, and is preferably a (meth)acrylate of a monohydroxy compound, particularly preferably an acrylate of a monohydroxy compound. The monohydroxy compound is particularly preferably an alkanoyl with an alkyl moiety having from 4 to 20 carbon atoms, a monocyclic, condensed polycyclic or bridged alicyclic monool, a poly (or mono)alkylene glycol monoalkyl (or aryl) ether. Particularly preferred as the monohydroxy compound is a C₆₋₂₀ alkanol or a bridged alicyclic monool. Further, when a cured product is to be used as a resist, it is preferred to use a bridged alicyclic monool, whereby the etching resistance will be improved.

As the compound (F), the following compounds may be mentioned.

Phenoxyethyl (meth)acrylate, 2-hydroxy-3-phenoxypropyl (meth)acrylate, phenoxydiethylene glycol (meth)acrylate, benzyl (meth)acrylate, methoxytriethylene glycol (meth)acrylate, methoxypolyethylene glycol (meth)acrylate, 2-(meth)acryloyloxyethyl hexahydrophthalate, behenyl (meth)acrylate, 2-(meth)acryloyloxyethyl succinate, stearyl (meth)acrylate, isostearyl (meth)acrylate, lauryl (meth)acrylate, 2-ethylhexyl (meth)acrylate, 3-(trimethoxysilyl)propyl (meth)acrylate, butyl (meth)acrylate, ethoxyethyl (meth)acrylate, methoxyethyl (meth)acrylate, glycidyl (meth)acrylate, tetrahydrofurfuryl (meth)acrylate, 2-hydroxyethyl (meth)acrylate, 2-hydroxypropyl (meth)acrylate, N,N-diethylaminoethyl (meth)acrylate, N,N-dimethylaminoethyl (meth)acrylate, dimethylaminoethyl (meth)acrylate, 2-methyl-2-adamantyl (meth)acrylate, 2-ethyl-2-adamantyl (meth)acrylate, 3-hydroxy-1-adamantyl (meth)acrylate, 1-adamantyl (meth)acrylate, isobornyl (meth)acrylate, 2-carboxyethyl (meth)acrylate, octyl (meth)acrylate, decyl (meth)acrylate, 2-(tert-butylamino)ethyl (meth)acrylate, 1,2,2,6,6-pentamethyl-4-piperidyl (meth)acrylate, n-butyl (meth)acrylate, tert-butyl (meth)acrylate, 4-tert-butylcyclohexyl (meth)acrylate, and the like.

The photocurable composition of the present invention preferably contains the compound (F). In such a case, one type or at least two types of the compound (F) may be contained in the photocurable composition. In a case where the photocurable composition contains the compound (F), the proportion of the compound (F) is preferably from 10 to 55 mass%, more preferably from 15 to 45 mass% to the photocurable composition (composition containing the compound (F)). When the proportion of the compound (F) is at least 10 mass%, the viscosity of the photocurable composition will be adjusted to be low, and the compatibility of the polymer (D) with the compound (E) and the compound (H) will be favorable. When the proportion of the compound (F) is at most 55 mass%, the sensitivity will be favorable, and the crosslink density will be high, whereby a cured product excellent in the mechanical strength will be obtained.

### (Compound (H))

The compound (H) is a compound having at least two (meth)acryloyloxy groups. The compound (H) may be a compound having fluorine atoms but is usually a compound having no fluorine atom.

The compound (H) is a component to improve the sensitivity of the photocurable composition. Further, depending upon the type of the compound (H), various physical properties of a cured product of the photocurable composition, such as the dry etching resistance, the wet etching resistance, the transparency, the viscosity, the refractive index, the hardness, the mechanical strength, the flexibility and the adhesion to a substrate will be adjusted.

The number of (meth)acryloyloxy groups in the compound (H) is suitably from 2 to 10, preferably from 2 to 6. If the number of (meth)acryloyloxy groups is too large, the obtainable cured product may be fragile. However, a compound having a particularly large number of (meth)acryloyloxy groups may be used if its amount is small.

The compound (H) may have a hydroxy group, so long as it is a poly(meth)acrylate of a polyhydroxy compound and has at least two (meth)acryloyloxy groups. The polyhydroxy compound may, for example, be an alkanepolyol, an alkylene oxide adduct of an alkanepolyol, a polyalkylene glycol, an alkylene oxide adduct of a compound having at least two functional groups to which an alkylene oxide can be added, such as a polyhydric phenol or a polyamine, a polycarbonate polyol or a polyester polyol. Further, the compound (H) may be a urethane (meth)acrylate which is a compound having a poly(meth)acrylate structure of a polyhydroxy compound. The urethane (meth)acrylate is a compound having a urethane bond, such as a compound obtainable by reacting a polyhydroxy compound with an isocyanatoalkyl (meth)acrylate or a compound obtainable by reacting a polyhydroxy compound with a polyisocyanate compound and a hydroxy group-containing (meth)acrylate. The polyhydroxy compound as the material of the urethane (meth)acrylate is preferably a polyether polyol such as an alkylene oxide adduct of an alkanepolyol, a polyalkylene glycol or an alkylene oxide adduct of a polyhydric phenol, and the polyisocyanate compound is preferably a non-yellowing polyisocyanate compound.

The compound (H) is preferably a poly(meth)acrylate of a polyhydroxy compound selected from the group consisting of an alkanepolyol, an alkylene oxide adduct of an alkanepolyol, a polyalkylene glycol and an alkylene oxide adduct of a polyhydric phenol, or a urethane (meth)acrylate obtainable by using a polyether polyol.

As the compound (H), the following compounds may be mentioned.

Bisphenol A di(meth)acrylate, di(meth)acrylate of a bisphenol A alkylene oxide adduct (such as ethoxylated bisphenol A di(meth)acrylate, propoxylated bisphenol A di(meth)acrylate, propoxylated ethoxylated bisphenol A di(meth)acrylate, bisphenol A glycelorate di(meth)acrylate or bisphenol A propoxylate glycelorate di(meth)acrylate), ethoxylated bisphenol F di(meth)acrylate, tricyclodecane dimethanol di(meth)acrylate, fluorene di(meth)acrylate, tricyclodecanedimethanol di(meth)acrylate, ethylene glycol di(meth)acrylate, dipropylene glycol di(meth)acrylate, 1,3-butandiol di(meth)acrylate, 1,4-butandiol di(meth)acrylate, glycerol 1,3-diglycelorate di(meth)acrylate, 1,6-hexanediol ethoxylate di(meth)acrylate, 1,6-hexanediolpropoxylate di(meth)acrylate, 1,6-hxanediol di(meth)acrylate, 3-hydroxy-2,2-dimethylpropionate di(meth)acrylate, 1,9-nonanediol di(meth)acrylate, 1,10-decandiol di(meth)acrylate, diethylene glycol di(meth)acrylate, neopentyl glycol di(meth)acrylate, neopentyl glycol propoxylate di(meth)acrylate, polyethylene glycol di(meth)acrylate, propylene glycol di(meth)acrylate, glycerol di(meth)acrylate, propylene glycol glycelorate di(meth)acrylate, polypropylene glycol di(meth)acrylate, polyethylene glycol di(meth)acrylate, tripropylene glycol di(meth)acrylate, triethylene glycol di(meth)acrylate, tetraethylene glycol di(meth)acrylate, tripropylene glycol glycelorate di(meth)acrylate, 2-hydroxy-3-acryloyloxypropyl (meth)acrylate, 2-methyl-1,3-propanediol diacrylate, trimethylolpropanebenzoate di(meth)acrylate, pentaerythritol di(meth)acrylate monostearate, trimethylolpropane ethoxylate methyl ether di(meth)acrylate, a di(meth)acrylate having at least two urethane bonds (such as UA-4200 manufactured by Shin-Nakamura Chemical Co., Ltd., or diurethane di(meth)acrylate), a di(meth)acrylate having a fluorene skeleton, 1,3-bis(3-methacryloyloxypropyl)-1,1,3,3-tetramethyldisiloxane, trimethylolpropane tri(meth)acrylate, trimethylpropane ethoxy tri(meth)acrylate, polyether triol tri(meth)acrylate, glycerinpropoxy tri(meth)acrylate, pentaerythritol tri(meth)acrylate, ethoxylated isocyanuric acid triacrylate, ethoxylated trimethylolpropane triacrylate, propoxylated trimethylolpropane triacrylate, pentaerythritol tetra(meth)acrylate, pentaerythritolethoxy tetra(meth)acrylate, ditrimethylolpropane tetra(meth)acrylate, propoxylated pentaerythritol tetraacrylate, dipentaerythritol hexa(meth)acrylate, a urethane di(meth)acrylate obtainable by using a polyether diol, a urethane tri(meth)acrylate obtainable by using a polyether triol, a urethane tetra(meth)acrylate obtainable by using a polyether tetraol, a urethane hexa(meth)acrylate obtainable by using a polyether hexaol, and the like.

The photocurable composition of the present invention preferably contains the compound (H). In such a case, one type or at least two types of the compound (H) may be contained in the photocurable composition. In a case where the photocurable composition contains the compound (H), the proportion of the compound (H) is preferably from 10 to 75 mass%, more preferably from 30 to 55 mass% to the photocurable composition (composition containing the compound (H)). When the proportion of the compound (H) is at least 10 mass%, the sensitivity of the photocurable composition will be improved. When the proportion of the compound (H) is at most 75 mass%, a photocurable composition in which the respective components are uniformly compatible with one another will be obtained.

### (Photopolymerization initiator (G))

The photopolymerization initiator (G) may, for example, be an acetophenone photopolymerization initiator, a benzoin photopolymerization initiator, a benzophenone photopolymerization initiator, a thioxanthone photopolymerization initiator, an a-aminoketone photopolymerization initiator, an α-hydroxyketone photopolymerization initiator, an α-acyloxime ester, benzyl-(o-ethoxycarbonyl)-α-monooxime, acylphosphine oxide, glyoxyester, 3-ketocoumarin, 2-ethylanthraquinone, camphorquinone, tetramethylthiuram sulfide, azobisisobutyronitrile, benzoyl peroxide, a dialkyl peroxide or tert-butylperoxy pivalate. From the viewpoint of the sensitivity and compatibility, an acetophenone photopolymerization initiator, a benzoin photopolymerization initiator, an α-aminoketone photopolymerization initiator or a benzophenone photopolymerization initiator is preferred.

As the acetophenone photopolymerization initiator, the following compounds may be mentioned.

Acetophenone, p-(tert-butyl) 1',1',1'-trichloroacetophenone, chloroacetophenone, 2',2'-diethoxyacetophenone, hydroxyacetophenone, 2,2-dimethoxy-2'-phenylacetophenone, 2-aminoacetophenone, a dialkylaminoacetophenone, etc.

As the benzoin photopolymerization initiator, the following compounds may be mentioned.

Benzyl, benzoin, benzoin methyl ether, benzoin ethyl ether, benzoin isopropyl ether, benzoin isobutyl ether, 1-hydroxycyclohexyl phenyl ketone, 2-hydroxy-2-methyl-1-phenyl-2-methylpropan-1-one, 1-(4-isopropylphenyl)-2-hydroxy-2-methylpropan-1-one, benzyl dimethyl ketal, etc.

As the α-aminoketone photopolymerization initiator, the following compounds may be mentioned.

2-Benzyl-2-dimethylamino-1-(4-morpholinophenyl)-butanone-1,2-methyl-1[4-(methylthio)phenyl]-2-morpholinopropan-1-one, etc.

As the benzophenone photopolymerization initiator, the following compounds may be mentioned.

Benzophenone, benzoyl benzoic acid, methyl benzoyl benzoate, methyl-o-benzoyl benzoate, 4-phenylbenzophenone, hydroxybenzophenone, hydroxypropylbenzophenone, acrylbenzophenone, 4,4'-bis(dimethylamino)benzophenone, etc.

The photocurable composition of the present invention usually contains the compound (G), and in such a case, one type or at least two types of the compound (G) may be contained in the photocurable composition. The proportion of the photopolymerization initiator (G) is preferably from 1 to 12 mass%, more preferably from 4 to 10 mass% to the photocurable composition (composition containing the photopolymerization initiator (G)). When the proportion of the photopolymerization initiator (G) is at least 1 mass%, it is possible to easily obtain a cured product without carrying out an operation of e.g. heating. When the proportion of the photopolymerization initiator (G) is at most 12 mass%, mixing can be carried out uniformly, whereby the photopolymerization initiator (G) remaining in the cured product will be less, and deterioration of the physical properties of the cured product can be suppressed.

### <<Other components>>

The photocurable composition may contain other components other than the polymer (D), the compound (E), the compound (F), the photopolymerization initiator (G) and the compound (H). Such other components may, for example, be a surfactant (which may be a fluorinated surfactant) other than the polymer (D), a photopolymerizable compound other than the compound (E), the compound (F) and the compound (H), a photosensitizer, a resin, metal oxide fine particles, a carbon compound, metal fine particles and another organic compound. The photocurable composition of the present invention does not necessarily require a surfactant other than the polymer (D) or a photopolymerizable compound other than the compound (E), the compound (F) and the compound (H). On the other hand, a photosensitizer, a resin, metal oxide fine particles, a carbon compound, metal fine particles and the like (hereinafter they will generically be referred to as additives (I)) may be contained in the photocurable composition of the present invention as the case requires.

The photosensitizer may, for example, be n-butylamine, di-n-butylamine, tri-n-butylphosphine, allylthiourea, s-benzyl isothiuronium-p-toluene sulfinate, or an amine compound such as triethylamine, diethylaminoethyl methacrylate, triethylene tetramine or 4,4'-bis(dialkylamino)benzophenone.

The resin may, for example, be a fluororesin, a polyester, a polyester oligomer, a polycarbonate or a poly(meth)acrylate.

The metal oxide fine particles may, for example, be titania, silica or zirconia.

The carbon compound may, for example, be carbon nanotubes or fullerene.

The metal fine particles may, for example, be copper or platinum.

Other organic compounds may, for example, be porphyrin, metal-encapsulated porphyrin, an ionic liquid (such as 1-hexyl-3-methylimidazolium chloride) and a dye.

In a case where the photocurable composition contains the above other components (particularly additives (I)), the total proportion of such other components is preferably at most 20 mass% to the photocurable composition (composition containing such other components). When the proportion of the additives (I) is at most 20 mass%, the photocurable composition can be uniformly mixed, and a homogeneous photocurable composition will be obtained.

With the above-described photocurable composition of the present invention, which comprises the relatively low molecular weight polymer (D) obtained by copolymerizing the specific compounds (A) to (C) in a specific proportion as a nonionic fluorinated surfactant, a cured product excellent in the release property can be formed without using a fluorinated surfactant made of a compound derived from perfluorooctanesulfonic acid as a material, and excellent compatibility of a fluorinated surfactant with other components will be obtained.

### <Process for producing molded product having fine pattern on its surface>

The process for producing a molded product having a fine pattern on its surface according to the present invention, comprises the following steps (1) to (3):
(1) a step of bringing the photocurable composition of the present invention in contact with a reverse pattern surface of a mold having the reverse pattern of said fine pattern on said surface,
(2) a step of irradiating the photocurable composition with light in such a state that the photocurable composition is in contact with the surface of the mold, to cure the photocurable composition to form a cured product, and
(3) a step of separating the mold from the cured product to obtain a molded product having a fine pattern on its surface.

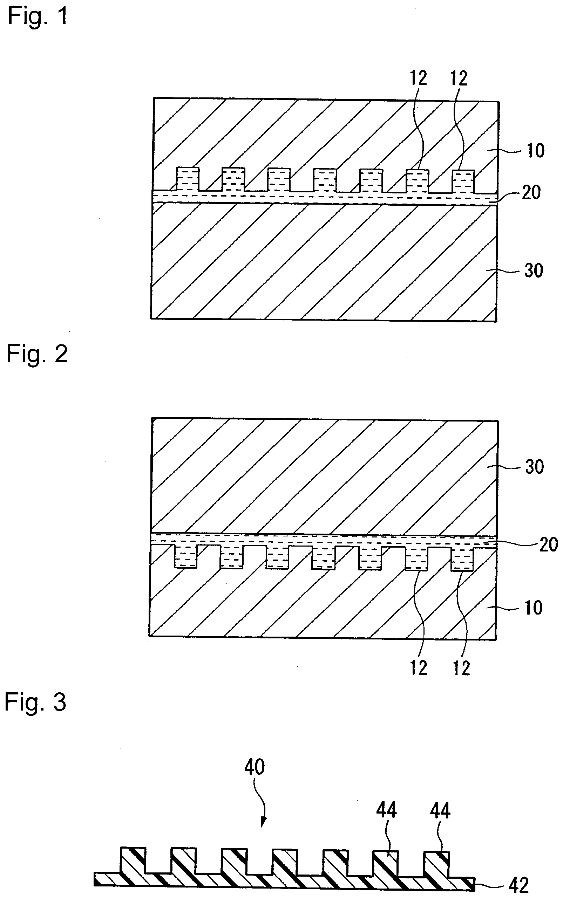

More specifically, the following processes (a) to (c) may be mentioned as the process for producing a molded product having a fine pattern on its surface according to the present invention.
PROCESS (a): A process comprising the following steps (a-1) to (a-4):
   (a-1) a step of placing the photocurable composition 20 on a surface of a substrate 30, as shown in Fig. 1,
   (a-2) a step of pressing a mold 10 against the photocurable composition 20 so that the reverse pattern 12 of the mold 10 is in contact with the photocurable composition 20, as shown in Fig. 1,
   (a-3) a step of irradiating the photocurable composition 20 with light in such a state that the mold 10 is pressed against the photocurable composition 20, to cure the photocurable composition 20 to form a cured product, and
   (a-4) a step of separating the mold 10, or the substrate 30 and the mold 10, from the cured product to obtain a molded product having a fine pattern on its surface.
PROCESS (b): A process comprising the following steps (b-1) to (b-4):
   (b-1) a step of placing the photocurable composition 20 on a surface of a mold 10, having the reverse pattern 12, as shown in Fig. 2,
   (b-2) a step of pressing a substrate 30 against the photocurable composition 20 on the surface of the mold 10, as shown in Fig. 2,
   (b-3) a step of irradiating the photocurable composition 20 with light in such a state that the substrate 30 is pressed against the photocurable composition 20, to cure the photocurable composition 20 to form a cured product, and
   (b-4) a step of separating the mold 10, or the substrate 30 and the mold 10, from the cured product to obtain a molded product having a fine pattern on its surface.
PROCESS (c): A process comprising the following steps (c-1) to (c-4):
   (c-1) a step of bringing a substrate 30 and a mold 10 close to or in contact with each other so that the reverse pattern 12 of the mold 10 is on the substrate 30 side, as shown in Fig. 1,
   (c-2) a step of filing the space between the substrate 30 and the mold 10 with the photocurable composition 20, as shown in Fig. 1,
   (c-3) a step of irradiating the photocurable composition 20 with light in such a state that the substrate 30 and the mold 10 are close to or in contact with each other, to cure the photocurable composition 20 to form a cured product, and
   (c-4) a step of separating the mold 10, or the substrate 30 and the mold 10, from the cured product to obtain a molded product having a fine pattern on its surface.

The substrate may, for example, be a substrate made of an inorganic material or a substrate made of an organic material.

As the inorganic material, a silicon wafer, glass, quartz glass, a metal (such as aluminum, nickel or copper), a metal oxide (such as alumina), silicon nitride, aluminum nitride or lithium niobate, may, for example, be mentioned.

As the organic material, a fluororesin, a silicone resin, an acrylic resin, a polycarbonate, a polyester (such as polyethylene terephthalate), a polyimide, a polypropylene, a polyethylene, a nylon resin, a polyphenylene sulfide or a cyclic polyolefin may, for example, be mentioned.

As the substrate, a surface-treated substrate may be employed, since it is excellent in the adhesion with the photocurable composition. The surface treatment may, for example, be primer-coating treatment, ozone treatment or plasma etching treatment. As the primer, polymethyl methacrylate, a silane coupling agent or silazane may, for example, be mentioned.

The mold may be a mold made of a non-light-transmitting material or a mold made of a light-transmitting material.

As the non-light-transmitting material, a silicon wafer, nickel, copper, stainless steel, titanium, SiC or mica may, for example, be mentioned.

As the light-transmitting material, quartz, glass, a polydimethylsiloxane, a cyclic polyolefin, a polycarbonate, a polyethylene terephthalate or a transparent fluororesin may, for example, be mentioned.

At least one of the substrate and the mold is made of a material which transmits at least 40% of light having a wavelength with which the photopolymerization initiator (G) is reactive.

The mold has a reverse pattern on its surface. The reverse pattern is a reverse pattern corresponding to the fine pattern on the surface of the molded product.

The reverse pattern has fine convexes and/or concaves.

The convexes may, for example, be long convex lines extending on the surface of the mold or protrusions dotted on the surface.

The concaves may, for example, be long grooves extending on the surface of the mold or holes dotted on the surface.

The shape of the convex lines or grooves may, for example, be linear, curved or bent. The convex lines or grooves may be a plurality of stripes extending in parallel with one another.

The cross-sectional shape of the convex lines or grooves in a direction perpendicular to the longitudinal direction may, for example, be rectangular, trapezoidal, triangular or semicircular.

The shape of the protrusions or holes may, for example, be triangular prism, quadrangular prism, hexagonal column, cylindrical column, triangular pyramid, quadrangular pyramid, hexagonal pyramid, circular cone, hemispherical or polyhedral.

The width of convex lines or grooves is preferably from 1 nm to 500 µm, more preferably from 10 nm to 100 µm, further preferably from 15 nm to 10 µm on average. The width of the convex lines means the length of the bottom in the cross section in a direction perpendicular to the longitudinal direction. The width of the grooves means the length of the upper side in the cross section in a direction perpendicular to the longitudinal direction.

The width of the protrusions or holes is preferably from 1 nm to 500 µm, more preferably from 10 nm to 100 µm, further preferably from 15 nm to 10 µm on average. The width of the protrusions means the length of the bottom in the cross section in a direction perpendicular to the longitudinal direction, in a case where the bottom side is elongated, or otherwise means the maximum length at the bottom surface of the protrusions. The width of the holes means the length of the upper side in the cross section in the direction perpendicular to the longitudinal direction when the opening is elongated, or otherwise, means the maximum length at the openings of the holes.

The height of the convexes is preferably from 1 nm to 500 µm, more preferably from 10 nm to 100 µm, further preferably from 15 nm to 10 µm on average.

The depth of the concaves is preferably from 1 nm to 500 µm, more preferably from 10 nm to 100 µm, further preferably from 15 nm to 10 µm on average.

In an area where the reverse pattern is dense, the distance between the adjacent convexes (or concaves) is preferably from 1 nm to 500 µm, more preferably from 1 nm to 50 µm, on average. The distance between the adjacent convexes means the distance from the terminal edge of the bottom in the cross section of a convex to the starting edge of the bottom in the cross section of the adjacent convex. The distance between the adjacent concaves means the distance from the terminal edge of the upper side in the cross section of a concave to the starting edge of the upper side in the cross section of the adjacent concave.

The minimum dimension of a convex is preferably from 1 nm to 50 µm, more preferably from 1 nm to 500 nm, particularly preferably from 1 nm to 50 nm. The minimum dimension means the minimum dimension among the width, length and height of the convex.

The minimum dimension of a concave is preferably from 1 nm to 50 µm, more preferably from 1 nm to 500 nm, particularly preferably from 1 nm to 50 nm. The minimum dimension means the minimum dimension among the width, length and depth of the concave.

### STEP (a-1):

The method for placing the photocurable composition may, for example, be an ink jetting method, a potting method, a spin coating method, a roll coating method, a casting method, a dip coating method, a die coating method, a Langmuir-Blodgett method or a vacuum vapor deposition method.

The photocurable composition may be placed over the entire surface of the substrate or on a part of the surface of the substrate.

### STEP (a-2):

The pressing pressure (gauge pressure) at the time of pressing the mold against the photocurable composition is preferably more than 0 and not more than 10 MPa, more preferably from 0.1 to 5 MPa. The temperature at the time of pressing the mold against the photocurable composition is preferably from 0 to 100°C, more preferably from 10 to 60°C.

### STEP (b-1):

The method for placing the photocurable composition may, for example, be an ink jetting method, a potting method, a spin coating method, a roll coating method, a casting method, a dip coating method, a die coating method, a Langmuir-Blodgett method or a vacuum vapor deposition method.

The photocurable composition may be placed over the entire surface of the reverse pattern of the mold, or on a part of the reverse pattern, and it is preferably placed over the entire surface of the reverse pattern.

### STEP (b-2):

The pressing pressure (gauge pressure) at the time of pressing the substrate against the photocurable composition is preferably more than 0 and not more than 10 MPa, more preferably from 0.1 to 5 MPa. The temperature at the time of pressing the substrate against the photocurable composition is preferably from 0 to 100°C, more preferably from 10 to 60°C.

### STEP (c-2):

The method for filing the space between the substrate and the mold with the photocurable composition may, for example, be a method of aspirating the photocurable composition into the space by a capillary phenomenon.

The temperature at the time of filling with the photocurable composition is preferably from 0 to 100°C, more preferably from 10 to 60°C.

### STEPS (a-3), (b-3) and (c-3):

The method for irradiation with light may, for example, be a method wherein using a mold made of a light-transmitting material, light is applied from the mold side, or using a substrate made of a light-transmitting material, light is applied from the substrate side. The wavelength of the light is preferably from 200 to 500 nm. At the time of irradiation with light, the photocurable composition may be heated to accelerate the curing.

The temperature at the time of irradiation with light is preferably from 0 to 100°C, more preferably from 10 to 60°C.

### STEPS (a-4), (b-4) and (c-4):

The temperature at the time of separating the mold, or the substrate and the mold, from the cured product, is preferably from 0 to 100°C, more preferably from 10 to 60°C.

In a case where the substrate and the mold are separated from the cured product, a molded product 40 having a fine pattern 44 on its surface is obtainable, which is composed solely of a cured product 42 having a surface on which a reverse pattern of the mold is transferred, as shown in Fig. 3.

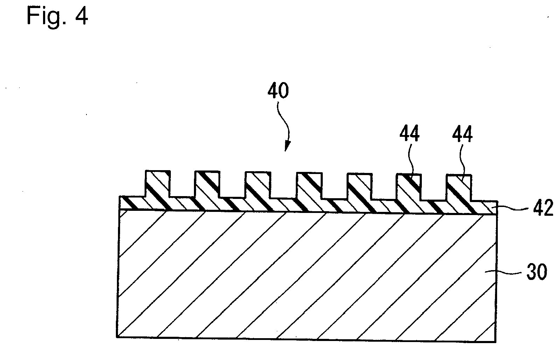

In a case where only the mold is separated from the cured product, a molded product 40 (laminate) having a fine pattern 44 on its surface is obtainable, which comprises the substrate 30 and the cured product 42 having a surface on which the reverse pattern of the mold is transferred, as shown in Fig. 4.

As the molded product having a fine pattern on its surface, the following articles may be mentioned.
Optical elements: A microlens array, an optical waveguide, an optical switching element (such as a grid polarizing element or a wavelength plate) a Fresnel zone plate element, a binary element, a blaze element, a photonic crystal, etc.
Antireflection components: An AR (anti reflection) coating component, etc.
Chips: A biochip, a chip for µ-TAS (micro-total analysis systems), a microreactor chip, etc.
Others: Recording media, a display material, a carrier for a catalyst, a filter, a sensor component, a resist which will be used for the preparation of semiconductor devices (including MEMS), a replica mold for electroforming (mother mold), a replica mold for imprint (daughter mold), etc.

When used as a resist, a fine pattern can be formed on a substrate by etching (dry etching or wet etching) the substrate by using the molded product having a fine pattern as a mask.

When used as a replica mold for electroforming, an electrically conductive layer is formed by electroless plating or metal deposition on the surface of the molded product having a fine pattern, and nickel is deposited on the surface of the electrically conductive layer by nickel electrolytic plating, whereby a nickel electroforming mold can be prepared. As the surface of the molded product has excellent release property, the prepared nickel electroforming mold can easily be separated from the molded product.

Further, the molded product having a fine pattern, which has high transparency and a high release property, may also be used as a replica mold for imprint. Particularly when a light-transmitting material is used as the substrate of the molded product, such a molded product can be used as a replica mold for photo nanoimprint.

By the above process for producing a molded product having a fine pattern on its surface according to the present invention, since the photocurable composition of the present invention with which a cured product excellent in the release property can be formed and which exhibits excellent compatibility between a fluorinated surfactant and other components, is used, it is possible to produce a molded product having on its surface a fine pattern having a reverse pattern of the mold precisely transferred, and having a uniform composition of the surface.

### EXAMPLES

Now, the present invention will be described in further detail with reference to Examples, but it should be understood that the present invention is by no means restricted to such Examples.

Examples 1, 5 to 7, 10, 12, 13, 17 to 32 and 37 to 46 are Working Examples of the present invention, and Examples 2 to 4, 8, 9, 11, 14 to 16 and 33 to 36 are Comparative Examples.

### (Mass average molecular weight)

The mass average molecular weight of the polymer (D) was measured by a GPC analysis apparatus (manufactured by Showa Denko K.K., GPC-101 model). Specifically, using columns (KF801, KF802 and KF803) manufactured by Showa Denko K.K., and using tetrahydrofuran as an eluent, the constituents of the polymer were separated, and the mass average molecular weight was determined using polymethyl methacrylate as a standard substance.

### (Viscosity)

The viscosity of the photocurable composition at 25°C was measured by a viscometer (manufactured by TOKI SANGYO CO., LTD., TV-20). The viscosity is one calibrated by a standard solution (JS50 (33.17 mPa·s at 25°C)). One having a viscosity of at most 300 mPa·s was judged as favorable.

### (Sensitivity)

The sensitivity of the photocurable composition was obtained as follows.

The photocurable composition was applied on the surface of a substrate by a spin coating method to form a coating film having a thickness of about 1.5 µm, which was irradiated with light from a high pressure mercury lamp (a light source having main wavelengths of 255, 315 and 365 nm at from 1.5 to 2.0 kHz), whereby the integrated quantity of light until the composition was completely cured, was obtained and taken as the sensitivity. Whether or not the photocurable composition was completely cured, was judged by measuring the IR spectrum to see the presence or absence of an olefin in an acrylic moiety. One having sensitivity of at most 500 mJ/cm² was judged to be good.

### (Contact angle)

The contact angle to water of the cured product was measured as follows.

The photocurable composition was dropped on the surface on the adhesive side of a polyethylene terephthalate (hereinafter referred to as PET) film (COSMOSHINE A4100 manufactured by TOYOBO CO., LTD.) and covered with a glass slide, and the photocurable composition was irradiated for 15 seconds with light from a high pressure mercury lamp (a light source having main wavelengths of 255, 315 and 365 nm at from 1.5 to 2.0 kHz) from the glass slide side to obtain a cured product.

With respect to the cured product, the contact angle was measured by using a contact angle meter (CA-X150 model, manufactured by Kyowa Interface Science Co., Ltd.) by dropping 4 µL of water on the surface of the cured product.

One having a contact angle of at least 80° was judged to be good. The contact angle is an index for the release property of the cured product.

Further, one having dispersion σ of the contact angles measured at several portions of at most 2.5 was judged to be good. The dispersion σ represents the uniformity of the composition of the surface of the cured product.

### (Compound (A))

Compound (A1-1): 3,3,4,4,5,5,6,6,7,7,8,8,8-Tridecafluorooctyl methacrylate (manufactured by ALDRICH)

   CH₂=C(CH₃)-C(O)O-(CH₂)₂-(CF₂)₆F (A1-1)

### (Compound (B))

Compound (B-1): Polyethylene glycol monomethacrylate (manufactured by NOF CORPORATION, number average molecular weight: 284)

   CH₂=C(CH₃)-C(O)O-(CH₂CH₂O)_{4.5}-H (B-1)
Compound (B-2): Polyethylene glycol monomethacrylate (manufactured by NOF CORPORATION, number average molecular weight: 438)

   CH₂=C(CH₃)-C(O)O-(CH₂CH₂O)₈-H (B-2)
Compound (B-3): Polyethylene glycol monomethacrylate (manufactured by NOF CORPORATION, number average molecular weight: 174)

   CH₂=C(CH₃)-C(O)O-(CH₂CH₂O)₂-H (B-3)
Compound (B-4): Methoxypolyethylene glycol monomethacrylate (manufactured by NOF CORPORATION, number average molecular weight: 276)

   CH₂=C(CH₃)-C(O)O-(CH₂CH₂O)₄-CH₃ (B-4)

### (Compound (C))

Compound (C-1): 2-Ethylhexyl methacrylate (manufactured by ALDRICH)

   CH₂=C(CH₃)-C(O)O-CH₂CH(C₂H₅)C₄H₉ (C-1)
Compound (C-2): Hexyl methacrylate (manufactured by ALDRICH)

   CH₂=C(CH₃)-C(O)O-C₆H₁₃ (C-2)
Compound (C-3): Isobutyl methacrylate (manufactured by ALDRICH)

   CH₂=C(CH₃)-C(O)O-CH(CH₃)C₂H₅ (C-3)
Compound (C-4): Dodecamethacrylate (manufactured by ALDRICH)

   CH₂=C(CH₃)-C(O)O-C₁₂H₂₅ (C-4)
Compound (C-5): Octadecamethacrylate (manufactured by ALDRICH)

   CH₂=C(CH₃)-C(O)O-C₁₈H₃₇ (C-5)

### (Compound (E))

Compound (E1-1): 3,3,4,4,5,5,6,6,7,7,8,8,8-Tridecafluorooctyl acrylate (manufactured by ALDRICH)

   CH₂=CH-C(O)O-(CH₂)₂-(CF₂)₆F (E1-1)

### (Compound (F))

Compound (F-1): 2-Methyl-2-adamantyl acrylate (manufactured by Idemitsu Kosan Co., Ltd.) 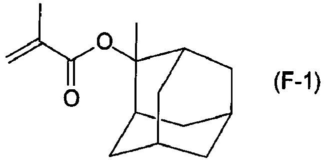
Compound (F-2): Isobornyl acrylate (manufactured by ALDRICH)
Compound (F-3): 2-Ethylhexyl acrylate (manufactured by ALDRICH)

### (Photopolymerization initiator (G))

Photopolymerization initiator (G-1): Manufactured by Ciba Geigy Specialty Chemicals, tradename: IRGACURE 651
Photopolymerization initiator (G-2): Manufactured by Ciba Geigy Specialty Chemicals, tradename: IRGACURE 184
Photopolymerization initiator (G-3): Manufactured by Ciba Geigy Specialty Chemicals, tradename: IRGACURE 907

### (Compound (H))

Compound (H-1): Tetraethylene glycol diacrylate (manufactured by Tokyo Chemical Industry Co., Ltd.)
Compound (H-2): Compound represented by the following formula (a mixture of a compound wherein R is a hydrogen atom and a compound wherein R is a methyl group) (manufactured by ALDRICH)

   CH₂=C(CH₃)-COO-CH₂CH₂OCONHCH₂-(C(CH₃)R-CH₂)₂-CH₂NHCOO-CH₂CH₂-OCO-C(CH₃)=CH₂
Compound (H-3): Polyether type urethane acrylate (tradename: UA-4200 (manufactured by Shin-Nakamura Chemical Co., Ltd.))
Compound (H-4): Neopentyl glycol dimethacrylate (manufactured by ALDRICH)
(Compound H-5): Tricyclodecane diacrylate (manufactured by ALDRICH)
(Compound H-6): Bisphenol A propoxy diacrylate (manufactured by ALDRICH)
(Compound H-7): Trimethylolpropane triacrylate (manufactured by Shin-Nakamura Chemical Co., Ltd.)
Compound (H-8): Pentaerythritol tetraacrylate (manufactured by ALDRICH)

### [Preparation Example 1]

Into a 100 mL pressure resistant reactor, 16.00 g of compound (A1-1), 16.68 g of compound (B-1), 7.32 g of compound (C-1), 3.88 g of octanethiol (manufactured by Wako Pure Chemical Industries, Ltd.) as a molecular weight adjusting agent, 40.00 g of ethyl acetate (manufactured by Wako Pure Chemical Industries, Ltd.) as a solvent and 0.60 g of dimethyl 2,2'-azobis(2-methylpropionate) (manufactured by Wako Pure Chemical Industries, Ltd.) as a polymerization initiator were charged, the atmosphere in the reactor was replaced with nitrogen, and polymerization was conducted at 70°C for 16 hours with stirring. After completion of the polymerization, ethyl acetate was distilled off under reduced pressure to obtain polymer (D-1).

### [Preparation Examples 2 to 11]

Polymers (D-2) to (D-11) were obtained in the same manner as in Preparation Example 1 except that the types and the charge ratios of the compounds (A) to (C) were changed as identified in Table 1.

### [Preparation Example 12]

Polymer (D-12) was obtained in the same manner as in Preparation Example 1 except that the types and the charge ratios of the compounds (A) to (C) were changed as identified in Table 1 and that 5.04 g of octanethiol as a molecular weight adjusting agent was used.

### [Preparation Example 13]

Polymer (D-13) was obtained in the same manner as in Preparation Example 1 except that the types and the charge ratios of the compounds (A) to (C) were changed as identified in Table 1 and that 5.82 g of octanethiol as a molecular weight adjusting agent was used.

### [Preparation Example 14]

Polymer (D-14) was obtained in the same manner as in Preparation Example 1 except that the types and the charge ratios of the compounds (A) to (C) were changed as identified in Table 1 and that 6.25 g of octanethiol as a molecular weight adjusting agent was used.

### [Preparation Example 15]

Polymer (D-15) was obtained in the same manner as in Preparation Example 1 except that the types and the charge ratios of the compounds (A) to (C) were changed as identified in Table 1 and that 1.94 g of octanethiol as a molecular weight adjusting agent was used.

### [Preparation Example 16]

Into a 100 mL pressure resistant reactor, 14.20 g of compound (A1-1), 9.94 g of compound (B-1), 4.26g of compound (C-1), 2.76 g of octanethiol (manufactured by Wako Pure Chemical Industries, Ltd.) as a molecular weight adjusting agent, 28.41 g of ethyl acetate (manufactured by Wako Pure Chemical Industries, Ltd.) as a solvent and 0.43 g of dimethyl 2,2'-azobis(2-methylpropionate) (manufactured by Wako Pure Chemical Industries, Ltd.) as a polymerization initiator were charged, the atmosphere in the reactor was replaced with nitrogen, and polymerization was conducted at 70°C for 16 hours with stirring. After completion of the polymerization, ethyl acetate was distilled off under reduced pressure to obtain polymer (D-16).

### [Preparation Examples 17 to 19]

Polymers (D-17) to (D-19) were obtained in the same manner as in Preparation Example 16 except that the types and the charge ratios of the compounds (A) to (C) were changed as identified in Table 1.

**[Table 1]**

| Polymer (D) | Compound (A) (mass%) | | Compound (B) (mass%) | | Compound (C) (mass%) | | Mass average molecular weight |
|---|---|---|---|---|---|---|---|
| D-1 | A1-1 | 40 | B-1 | 42 | C-1 | 18 | 4520 |
| D-2 | A1-1 | 40 | B-2 | 42 | C-1 | 18 | 4950 |
| D-3 | A1-1 | 40 | B-3 | 42 | C-1 | 18 | 4950 |
| D-4 | A1-1 | 40 | B-4 | 42 | C-1 | 18 | 2600 |
| D-5 | A1-1 | 40 | B-1 | 42 | C-2 | 18 | 3880 |
| D-6 | A1-1 | 40 | B-1 | 42 | C-3 | 18 | 4020 |
| D-7 | A1-1 | 40 | B-1 | 42 | C-4 | 18 | 4020 |
| D-8 | A1-1 | 40 | B-1 | 42 | C-5 | 18 | 4180 |
| D-9 | A1-1 | 60 | B-1 | 28 | C-1 | 12 | 3220 |
| D-10 | A1-1 | 25 | B-1 | 52 | C-1 | 23 | 4200 |
| D-11 | A1-1 | 10 | B-1 | 60 | C-1 | 30 | 3120 |
| D-12 | A1-1 | 40 | B-1 | 42 | C-1 | 18 | 2560 |
| D-13 | A1-1 | 40 | B-1 | 42 | C-1 | 18 | 1060 |
| D-14 | A1-1 | 40 | B-1 | 42 | C-1 | 18 | 850 |
| D-15 | A1-1 | 40 | B-1 | 42 | C-1 | 18 | 7540 |
| D-16 | A1-1 | 50 | B-1 | 35 | C-1 | 15 | 3500 |
| D-17 | A1-1 | 20 | B-1 | 75 | C-1 | 5 | 5010 |
| D-18 | A1-1 | 40 | B-1 | 60 | C-1 | 0 | 4680 |
| D-19 | A1-1 | 25 | B-1 | 30 | C-1 | 45 | 3370 |

### [Example 1]

To a vial container (inner volume: 13 mL), 0.04 g of polymer (D-1), 2.00 g of compound (E1-1), 4.00 g of compound (F-1) and 3.36 g of compound (H-1) were added, and then 0.60 g of photopolymerization initiator (G-1) was mixed thereto, followed by filtration by a filter made of polyethylene terephthalate of 0.2 µm, to obtain a photocurable composition. The composition of the photocurable composition is shown in Table 2, and the evaluation results are shown in Table 3.

### [Examples 2 to 43]

Photocurable compositions were obtained in the same manner as in Example 1 except that the compositions were changed as identified in Table 2. The evaluation results are shown in Table 3.

**[Table 2-1]**

| Ex. | Polymer (D) (mass%) | | Compound (E) (mass%) | | Compound (F) (mass%) | | Photopolymerization Initiator (G) (mass%) | | Compound (H) (mass%) | |
|---|---|---|---|---|---|---|---|---|---|---|
| 1 | D-1 | 0.4 | E1-1 | 20 | F-1 | 40 | G-1 | 6 | H-1 | 33.6 |
| 2 | D-2 | 0.4 | E1-1 | 20 | F-1 | 40 | G-1 | 6 | H-1 | 33.6 |
| 3 | D-3 | 0.4 | E1-1 | 20 | F-1 | 40 | G-1 | 6 | H-1 | 33.6 |
| 4 | D-4 | 0.4 | E1-1 | 20 | F-1 | 40 | G-1 | 6 | H-1 | 33.6 |
| 5 | D-5 | 0.4 | E1-1 | 20 | F-1 | 40 | G-1 | 6 | H-1 | 33.6 |
| 6 | D-6 | 0.4 | E1-1 | 20 | F-1 | 40 | G-1 | 6 | H-1 | 33.6 |
| 7 | D-7 | 0.4 | E1-1 | 20 | F-1 | 40 | G-1 | 6 | H-1 | 33.6 |
| 8 | D-8 | 0.4 | E1-1 | 20 | F-1 | 40 | G-1 | 6 | H-1 | 33.6 |
| 9 | D-9 | 0.4 | E1-1 | 20 | F-1 | 40 | G-1 | 6 | H-1 | 33.6 |
| 10 | D-10 | 0.4 | E1-1 | 20 | F-1 | 40 | G-1 | 6 | H-1 | 33.6 |
| 11 | D-11 | 0.4 | E1-1 | 20 | F-1 | 40 | G-1 | 6 | H-1 | 33.6 |
| 12 | D-12 | 0.4 | E1-1 | 20 | F-1 | 40 | G-1 | 6 | H-1 | 33.6 |
| 13 | D-13 | 0.4 | E1-1 | 20 | F-1 | 40 | G-1 | 6 | H-1 | 33.6 |
| 14 | D-14 | 0.4 | E1-1 | 20 | F-1 | 40 | G-1 | 6 | H-1 | 33.6 |
| 15 | D-15 | 0.4 | E1-1 | 20 | F-1 | 40 | G-1 | 6 | H-1 | 33.6 |
| 16 | - | - | E1-1 | 20 | F-1 | 40 | G-1 | 6 | H-1 | 34.0 |
| 17 | D-1 | 0.4 | E1-1 | 20 | F-2 | 40 | G-1 | 6 | H-1 | 33.6 |
| 18 | D-1 | 0.4 | E1-1 | 20 | F-3 | 40 | G-1 | 6 | H-1 | 33.6 |
| 19 | D-1 | 0.4 | E1-1 | 20 | F-1 | 40 | G-2 | 6 | H-1 | 33.6 |
| 20 | D-1 | 0.4 | E1-1 | 20 | F-1 | 40 | G-3 | 6 | H-1 | 33.6 |
| 21 | D-1 | 0.4 | E1-1 | 20 | F-1 | 40 | G-1 | 6 | H-2 | 33.6 |
| 22 | D-1 | 0.4 | E1-1 | 20 | F-1 | 40 | G-1 | 6 | H-3 | 33.6 |
| 23 | D-1 | 0.4 | E1-1 | 20 | F-1 | 40 | G-1 | 6 | H-4 | 33.6 |
| 24 | D-1 | 0.4 | E1-1 | 20 | F-1 | 40 | G-1 | 6 | H-5 | 33.6 |
| 25 | D-1 | 0.4 | E1-1 | 20 | F-1 | 40 | G-1 | 6 | H-6 | 33.6 |

**[Table 2-2]**

| Ex. | Polymer (D) (mass%) | | Compound (E) (mass%) | | Compound (F) (mass%) | | Photopolymerization Initiator (G) (mass%) | | Compound (H) (mass%) | |
|---|---|---|---|---|---|---|---|---|---|---|
| 26 | D-1 | 0.4 | E1-1 | 20 | F-1 | 40 | G-1 | 6 | H-1+H-2 | 23.6+10 |
| 27 | D-1 | 0.4 | E1-1 | 20 | F-1 | 40 | G-1 | 6 | H-1+H-5 | 23.6+10 |
| 28 | D-1 | 0.4 | E1-1 | 20 | F-1 | 40 | G-1 | 6 | H-1+H-7 | 23.6+10 |
| 29 | D-1 | 0.4 | E1-1 | 20 | F-1 | 40 | G-1 | 6 | H-1+H-8 | 23.6+10 |
| 30 | D-1 | 0.4 | E1-1 | 20 | F-1 | 40 | G-1 | 6 | H-4+H-7 | 23.6+10 |
| 31 | D-1 | 0.4 | E1-1 | 20 | F-1 | 40 | G-1 | 6 | H-5+H-8 | 23.6+10 |
| 32 | D-1 | 0.4 | E1-1 | 11 | F-1 | 12 | G-1 | 6 | H-5+H-8 | 30.6+40 |
| 33 | D-16 | 0.4 | E1-1 | 20 | F-1 | 40 | G-1 | 6 | H-1 | 33.6 |
| 34 | D-17 | 0.4 | E1-1 | 20 | F-1 | 40 | G-1 | 6 | H-1 | 33.6 |
| 35 | D-18 | 0.4 | E1-1 | 20 | F-1 | 40 | G-1 | 6 | H-1 | 33.6 |
| 36 | D-19 | 0.4 | E1-1 | 20 | F-1 | 40 | G-1 | 6 | H-1 | 33.6 |
| 37 | D-1 | 3.1 | E1-1 | 19.5 | F-1 | 38.9 | G-1 | 5.8 | H-5+H-8 | 23+9.7 |
| 38 | D-1 | 0.05 | E1-1 | 20 | F-1 | 40 | G-1 | 6 | H-5+H-8 | 23.95+10 |
| 39 | D-1 | 0.4 | E1-1 | 8 | F-1 | 19 | G-1 | 6 | H-5+H-8 | 42+24.6 |
| 40 | D-1 | 0.4 | E1-1 | 30 | F-3 | 30.6 | G-1 | 6 | H-4 | 33 |
| 41 | D-1 | 0.4 | E1-1 | 15 | F-1 | 50 | G-1 | 8 | H-1 | 26.6 |
| 42 | D-1 | 0.4 | E1-1 | 20 | F-1 | 35 | G-1 | 3 | H-1 | 41.6 |
| 43 | D-1 | 3 | E1-1 | 30 | F-1 | 40 | G-1 | 9 | H-1 | 18 |

**[Table 3]**

| Ex. | Viscosity (mPa·s) | Sensitivity (mJ/cm²) | Contact angle (degree) | Dispersion σ of contact angle |
|---|---|---|---|---|
| 1 | 16 | 441 | 84 | 1.2 |
| 2 | 16 | 441 | 82 | 2.9 |
| 3 | 16 | 441 | 82 | 4.6 |
| 4 | 16 | 441 | 81 | 2.8 |
| 5 | 16 | 441 | 85 | 2.1 |
| 6 | 16 | 441 | 85 | 1.7 |
| 7 | 16 | 441 | 87 | 2.1 |
| 8 | 16 | 441 | 85 | 4.4 |
| 9 | 16 | 441 | 78 | 2.7 |
| 10 | 16 | 441 | 90 | 2.3 |
| 11 | 16 | 441 | 77 | 2.1 |
| 12 | 16 | 441 | 85 | 2.5 |
| 13 | 16 | 441 | 86 | 0.8 |
| 14 | 16 | 441 | 87 | 3.1 |
| 15 | 16 | 441 | 82 | 4.6 |
| 16 | 16 | 441 | 75 | 1.6 |
| 17 | 12 | 441 | 84 | 1.3 |
| 18 | 10 | 441 | 84 | 1.4 |
| 19 | 16 | 441 | 83 | 1.2 |
| 20 | 16 | 441 | 84 | 1.1 |
| 21 | 56 | 441 | 86 | 1.3 |
| 22 | 85 | 441 | 88 | 1.3 |
| 23 | 14 | 441 | 88 | 1.4 |
| 24 | 35 | 441 | 89 | 1.2 |
| 25 | 23 | 441 | 87 | 1.3 |
| 26 | 54 | 441 | 84 | 1.3 |
| 27 | 25 | 441 | 86 | 1.4 |
| 28 | 22 | 441 | 83 | 1.2 |
| 29 | 33 | 441 | 84 | 1.3 |
| 30 | 29 | 441 | 85 | 1.3 |
| 31 | 41 | 441 | 86 | 1.5 |
| 32 | 78 | 441 | 84 | 1.4 |
| 33 | 16 | 441 | 71 | 5.2 |
| 34 | 16 | 441 | 75 | 3.0 |
| 35 | 16 | 441 | 75 | 4.1 |
| 36 | 16 | 441 | 79 | 2.9 |
| 37 | 45 | 441 | 82 | 2.2 |
| 38 | 41 | 441 | 84 | 2.1 |
| 39 | 68 | 441 | 85 | 1.9 |
| 40 | 4 | 441 | 90 | 2.3 |
| 41 | 10 | 441 | 85 | 2.1 |
| 42 | 16 | 441 | 89 | 1.3 |
| 43 | 11 | 441 | 87 | 2.3 |

### [Example 44]

One droplet of the photocurable composition in Example 1 was dropped on the surface of a silicon wafer at 25°C to obtain a silicon wafer uniformly coated with the composition. A quartz mold having on its surface convexes with a width of 800 nm, a height of 180 nm and a length of 10 µm, was pressed against the photocurable composition on the silicon wafer, followed by pressing under 0.5 MPa (gauge pressure) as it was.

Then, at 25°C, the photocurable composition was irradiated for 15 seconds with light from a high pressure mercury lamp (a light source having main wavelengths of 255, 315 and 365 nm at from 1.5 to 2.0 kHz) from the mold side, to obtain a cured product of the photocurable composition. At 25°C, the mold was separated from the silicon wafer to obtain a molded product having formed on the surface of the silicon wafer, a cured product having on its surface concaves having the convexes of the mold inverted. The depths of the concaves were from 178 to 180 nm.

Then, using the molded product as a mask, dry etching was carried out by a dry etching apparatus manufactured by SAMCO INC. using a mixed gas of 40 seem of CF₄ and 10 sccm of oxygen, under conditions of 5 Pa and 70W for 120 seconds. A pattern with a width of 805 nm, a depth of 30 nm and a length of 10 µm could be formed on silicon.

### [Example 45]

One droplet of the photocurable composition in Example 30 was dropped on the surface on the adhesive side of a PET film (manufactured by TOYOBO CO., LTD., tradename: COSMOSHINE A4100) at 25°C to obtain a PET film uniformly coated with the composition. A quartz mold having on its surface convexes with a width of 800 nm, a height of 180 nm and a length of 10 µm was pressed against the photocurable composition on the PET film, followed by pressing under 0.5 MPa (gauge pressure) as it was.

Then, at 25°C, the photocurable composition was irradiated for 15 seconds with light from a high pressure mercury lamp (a light source having main wavelengths of 255, 315 and 365 nm at from 1.5 to 2.0 kHz) from the mold side, to obtain a cured product of the photocurable composition. At 25°C, the mold was separated from the PET film to obtain a molded product having formed on the surface of the PET film, a cured product having on its surface concaves having the convexes of the mold inverted. The depths of the concaves were from 178 to 180 nm.

Then, the molded product was used as a replica mold for nanoimprint. Specifically, one drop of the photocurable composition in Example 1 was dropped on the surface on the adhesive side of a PET film (manufactured by TOYOBO CO., LTD., tradename: COSMOSHINE A4100) to form a PET film uniformly coated with the composition. The replica mold was pressed against the photocurable composition on the PET film, and while a pressure of 5 MPa was applied at 25°C, the photocurable composition was irradiated for 15 seconds with light from a high pressure mercury lamp (a light source having main wavelengths of 255, 315 and 365 nm at from 1.5 to 2.0 kHz) from the replica mold side, to obtain a cured product of the photocurable composition in Example 1. At 25°C, the replica mold was separated from the PET film to obtain a molded product having formed on the surface of the PET film, a cured product having on its surface convexes having the concaves of the mold inverted. The heights of the convexes were from 175 to 177 nm.

### [Example 46]

One droplet of the photocurable composition in Example 30 was dropped on the surface on the adhesive side of a PET film (manufactured by TOYOBO CO., LTD., tradename: COSMOSHINE A4100) at 25°C to obtain a PET film uniformly coated with the composition. A quartz mold having on its surface convexes with a width of 800 nm, a height of 180 nm and a length of 10 µm was pressed against the photocurable composition on the PET film, followed by pressing under 0.5 MPa (gauge pressure) as it was.

Then, at 25°C, the photocurable composition was irradiated for 15 seconds with light from a high pressure mercury lamp (a light source having main wavelengths of 255, 315 and 365 nm at from 1.5 to 2.0 kHz) from the mold side, to obtain a cured product of the photocurable composition. At 25°C, the mold was separated from the PET film to obtain a molded product having formed on the surface of the PET film, a cured product having on its surface concaves having the convexes of the mold inverted. The depths of the concaves were from 178 to 180 nm.

Then, the molded product was used as a replica mold for nickel electroforming. Specifically, the replica mold was immersed in an electroless nickel plating solution (manufactured by Kojundo Chemical Laboratory Co., Ltd.) to form a nickel layer on its surface. Then, the replica mold provided with a nickel layer was immersed in a nickel electrolytic plating solution, and electricity was applied to the solution to carry out nickel electroforming. When the thickness of the nickel layer reached about 200 µm, the plating operation was stopped, the replica mold provided with a nickel layer was pulled out of the nickel electrolytic plating solution, and the nickel mold and the replica mold were separated.

The heights of the convexes of the obtained nickel mold were from 178 to 180 nm.

### INDUSTRIAL APPLICABILITY

The molded product having a fine pattern on its surface, obtainable by the production process of the present invention, is useful as an optical element, an antireflection member, biochips, microreactor chips, a recording medium, a catalyst carrier, a resist for production of semiconductor devices, a replica mold for imprint, a replica mold for electroforming, and the like.

### REFERENCE SYMBOLS

- 10:: mold
- 12:: reverse pattern
- 20:: photocurable composition
- 30:: substrate
- 40:: molded product
- 42:: cured product
- 44:: fine pattern

## Claims

1. A photocurable composition for imprint, containing, as the main component, a compound having at least one acryloyloxy group or methacryloyloxy group, and further comprising a polymer (D) which is a copolymer of the following compound (A), the following compound (B) and the following compound (C) in a proportion of units of the compound (A) of from 20 to 45 mass%, a proportion of units of the compound (B) of from 20 to 65 mass% and a proportion of units of the compound (C) of from 5 to 40 mass%, to the total amount of the units of the compound (A), the units of the compound (B) and the units of the compound (C), and which has a mass average molecular weight of from 1,000 to 5,000:
compound (A): a compound represented by the following formula (1):
CH₂=C(R¹¹)-C(O)O-Q-R^{f} (1)
wherein R¹¹ is a hydrogen atom or a methyl group, Q is a single bond or a bivalent linking group containing no fluorine atom, and R^{f} is a polyfluoroalkyl group with a main chain having from 1 to 6 carbon atoms, which may have an etheric oxygen atom between the carbon atoms;
compound (B): a compound represented by the following formula (2), which has a number average molecular weight of at most 350:
CH₂=C(R²¹)-C(O)O-(CH²CH(R²²)O)ₙ -H (2)
wherein R²¹ is a hydrogen atom or a methyl group, R²² is a hydrogen atom or a C₁₋₄ alkyl group, and n is from 3 to 6, provided that R²²'s in one molecule may be the same or different from one another;
compound (C): a compound represented by the following formula (3):
CH₂=C(R³¹)-C(O)O-R³² (3)
wherein R³¹ is a hydrogen atom or a methyl group, and R³² is a C₂₋₁₅ monovalent aliphatic hydrocarbon group.

2. The photocurable composition according to Claim 1, wherein the proportion of the polymer (D) in the photocurable composition is from 0.01 to 5 mass% to the photocurable composition.

3. The photocurable composition according to Claim 1 or 2, wherein at least part of the compound having at least one acryloyloxy group or methacryloyloxy group is a compound having one acryloyloxy group or methacryloyloxy group.

4. The photocurable composition according to Claim 3, wherein at least part of the compound having one acryloyloxy group or methacryloyloxy group is a compound (E) having fluorine atoms, and the proportion of the compound (E) in the photocurable composition is from 5 to 40 mass% to the photocurable composition.

5. The photocurable composition according to Claim 3, wherein at least part of the compound having one acryloyloxy group or methacryloyloxy group is a compound (F) having no fluorine, and the proportion of the compound (F) in the photocurable composition is from 10 to 55 mass% to the photocurable composition.

6. The photocurable composition according to Claim 1 or 2, wherein at least part of the compound having at least one acryloyloxy group or methacryloyloxy group is a compound (H) having at least two acryloyloxy groups or methacryloyloxy groups, and the proportion of the compound (H) in the photocurable composition is from 10 to 75 mass% to the photocurable composition.

7. The photocurable composition according to any one of Claims 1 to 6, which contains a photopolymerization initiator (G) in an amount of from 1 to 12 mass% to the photocurable composition.

8. The photocurable composition according to any one of Claims 1 to 7, which has a viscosity at 25°C of from 3 to 200 mPa·s.

9. A process for producing a molded product having a fine pattern on its surface, which comprises:
a step of bringing the photocurable composition for imprint as defined in any one of Claims 1 to 8 into contact with a reverse pattern surface of a mold having the reverse pattern of said fine pattern on said surface,
a step of irradiating the photocurable composition with light in such a state that the photocurable composition is in contact with the surface of the mold, to cure the photocurable composition to form a cured product, and
a step of separating the mold from the cured product to obtain a molded product having a fine pattern on its surface.

10. The process for producing a molded product having a fine pattern on its surface according to Claim 9, which comprises:
a step of placing the photocurable composition for imprint as defined in any one of Claims 1 to 8 on a surface of a substrate,
a step of pressing a mold having a reverse pattern of said fine pattern on its surface against the photocurable composition so that the reverse pattern of the mold is in contact with the photocurable composition,
a step of irradiating the photocurable composition with light in such a state that the mold is pressed against the photocurable composition, to cure the photocurable composition to form a cured product, and
a step of separating the mold, or the substrate and the mold, from the cured product to obtain a molded product having a fine pattern on its surface.

11. The process for producing a molded product having a fine pattern on its surface according to Claim 9, which comprises:
a step of placing the photocurable composition for imprint as defined in any one of Claims 1 to 8 on a reverse pattern surface of a mold having the reverse pattern of said fine pattern on said surface,
a step of pressing a substrate against the photocurable composition,
a step of irradiating the photocurable composition with light in such a state that the substrate is pressed against the photocurable composition, to cure the photocurable composition to form a cured product, and
a step of separating the mold, or the substrate and the mold, from the cured product to obtain a molded product having a fine pattern on its surface.

12. The process for producing a molded product having a fine pattern on its surface according to Claim 9, which comprises:
a step of bringing a substrate and a mold having a reverse pattern of said fine pattern on its surface close to or in contact with each other so that the reverse pattern of the mold is on the substrate side,
a step of filling the space between the substrate and the mold with the photocurable composition for imprint as defined in any one of Claims 1 to 8,
a step of irradiating the photocurable composition with light in such a state that the substrate and the mold are close to or in contact with each other, to cure the photocurable composition to form a cured product, and
a step of separating the mold, or the substrate and the mold, from the cured product to obtain a molded product having a fine pattern on its surface.

13. The process for producing a molded product having a fine pattern on its surface according to any one of Claims 9 to 12, wherein the molded product having a fine pattern on its surface is a replica mold for imprint.

14. The process for producing a molded product having a fine pattern on its surface according to any one of Claims 9 to 12, wherein the molded product having a fine pattern on its surface is a replica mold for electroforming.

## Patentansprüche

1. Lichthärtbare Zusammensetzung für Abdruck, enthaltend, als den Hauptbestandteil, eine Verbindung mit mindestens einer Acryloyloxy-Gruppe oder Methacryloyloxy-Gruppe und weiter umfassend ein Polymer (D), das ein Copolymer der folgenden Verbindung (A), der folgenden Verbindung (B) und der folgenden Verbindung (C) in einem Verhältnis von Einheiten der Verbindung (A) von 20 bis 45 Massen%, einem Verhältnis von Einheiten der Verbindung (B) von 20 bis 65 Massen% und einem Verhältnis von Einheiten der Verbindung (C) von 5 bis 40 Massen% zu der Gesamtmenge der Einheiten der Verbindung (A), der Einheiten der Verbindung (B) und der Einheiten der Verbindung (C) ist und das eine massengemittelte Molekülmasse von 1000 bis 5000 aufweist:
Verbindung (A): eine Verbindung, dargestellt durch die folgende Formel (1):
CH₂=C(R¹¹)-C(O)O-Q-R^{f} (1)
wobei R¹¹ ein Wasserstoffatom oder eine Methyl-Gruppe ist, Q eine Einfachbindung oder eine zweiwertige Verknüpfungsgruppe, die kein Fluoratom enthält, ist und R^{f} eine Polyfluoralkyl-Gruppe mit einer Hauptkette, die von 1 bis 6 Kohlenstoffatome aufweist, welche ein etherisches Sauerstoffatom zwischen den Kohlenstoffatomen aufweisen kann, ist;
Verbindung (B): eine Verbindung, dargestellt durch die folgende Formel (2), die ein Molekulargewicht-Zahlenmittel von höchstens 350 aufweist:
CH₂=C(R²¹)-C(O)O-(CH₂CH(R²²)O)ₙ-H (2)
wobei R²¹ ein Wasserstoffatom oder eine Methyl-Gruppe ist, R²² ein Wasserstoffatom oder eine C₁₋₄-Alkyl-Gruppe ist und n von 3 bis 6 entspricht, mit der Maßgabe, dass die R²² in einem Molekül gleich oder unterschiedlich voneinander sein können;
Verbindung (C): eine Verbindung, dargestellt durch die folgende Formel (3):
CH₂=C(R³¹)-C(O)O-R³² (3)
wobei R³¹ ein Wasserstoffatom oder eine Methyl-Gruppe ist und R³² eine einwertige aliphatische C₂₋₁₅-Kohlenwasserstoff-Gruppe ist.

2. Lichthärtbare Zusammensetzung nach Anspruch 1, wobei das Verhältnis des Polymers (D) in der lichthärtbaren Zusammensetzung von 0,01 bis 5 Massen% zu der lichthärtbaren Zusammensetzung beträgt.

3. Lichthärtbare Zusammensetzung nach Anspruch 1 oder 2, wobei mindestens ein Teil der Verbindung mit mindestens einer Acryloyloxy-Gruppe oder Methacryloyloxy-Gruppe eine Verbindung ist, die eine Acryloyloxy-Gruppe oder Methacryloyloxy-Gruppe aufweist.

4. Lichthärtbare Zusammensetzung nach Anspruch 3, wobei mindestens ein Teil der Verbindung mit einer Acryloyloxy-Gruppe oder Methacryloyloxy-Gruppe eine Verbindung (E) ist, die Fluoratome aufweist, und das Verhältnis der Verbindung (E) in der lichthärtbaren Zusammensetzung von 5 bis 40 Massen% zu der lichthärtbaren Zusammensetzung beträgt.

5. Lichthärtbare Zusammensetzung nach Anspruch 3, wobei mindestens ein Teil der Verbindung mit einer Acryloyloxy-Gruppe oder Methacryloyloxy-Gruppe eine Verbindung (F) ist, die kein Fluor aufweist, und das Verhältnis der Verbindung (F) in der lichthärtbaren Zusammensetzung von 10 bis 55 Massen% zu der lichthärtbaren Zusammensetzung beträgt.

6. Lichthärtbare Zusammensetzung nach Anspruch 1 oder 2, wobei mindestens ein Teil der Verbindung mit mindestens einer Acryloyloxy-Gruppe oder Methacryloyloxy-Gruppe eine Verbindung (H) ist, die mindestens zwei Acryloyloxy-Gruppen oder Methacryloyloxy-Gruppen aufweist, und das Verhältnis der Verbindung (H) in der lichthärtbaren Zusammensetzung von 10 bis 75 Massen% zu der lichthärtbaren Zusammensetzung beträgt.

7. Lichthärtbare Zusammensetzung nach einem der Ansprüche 1 bis 6, die einen Photopolymerisationsinitiator (G) in einer Menge von 1 bis 12 Massen% zu der lichthärtbaren Zusammensetzung enthält.

8. Lichthärtbare Zusammensetzung nach einem der Ansprüche 1 bis 7, die eine Viskosität bei 25°C von 3 bis 200 mPa·s aufweist.

9. Verfahren zur Herstellung eines geformten Produkts mit einem feinen Muster auf seiner Oberfläche, das umfasst:
einen Schritt des Inkontaktbringens der lichthärtbaren Zusammensetzung für Abdruck nach einem der Ansprüche 1 bis 8 mit einer Negativmusteroberfläche einer Form, die das Negativmuster des feinen Musters auf der Oberfläche aufweist,
einen Schritt des Bestrahlens der lichthärtbaren Zusammensetzung mit Licht in so einem Zustand, dass die lichthärtbare Zusammensetzung in Kontakt mit der Oberfläche der Form ist, um die lichthärtbare Zusammensetzung zu härten, um ein gehärtetes Produkt zu bilden, und
einen Schritt des Trennens der Form von dem gehärteten Produkt, um ein geformtes Produkt mit einem feinen Muster auf seiner Oberfläche zu erhalten.

10. Verfahren zur Herstellung eines geformtes Produkts mit einem feinen Muster auf seiner Oberfläche nach Anspruch 9, das umfasst:
einen Schritt des Anordnens der lichthärtbaren Zusammensetzung für Abdruck nach einem der Ansprüche 1 bis 8 auf einer Oberfläche eines Substrats,
einen Schritt des Drückens einer Form mit einem Negativmuster des feinen Musters auf ihrer Oberfläche gegen die lichthärtbare Zusammensetzung, so dass das Negativmuster der Form mit der lichthärtbaren Zusammensetzung in Kontakt ist,
einen Schritt des Bestrahlens der lichthärtbaren Zusammensetzung mit Licht in so einem Zustand, dass die Form gegen die lichthärtbare Zusammensetzung gedrückt wird, um die lichthärtbare Zusammensetzung zu härten, um ein gehärtetes Produkt zu bilden, und
einen Schritt des Trennens der Form oder des Substrats und der Form von dem gehärteten Produkt, um ein geformtes Produkt mit einem feinen Muster auf seiner Oberfläche zu erhalten.

11. Verfahren zur Herstellung eines geformtes Produkts mit einem feinen Muster auf seiner Oberfläche nach Anspruch 9, das umfasst:
einen Schritt des Anordnens der lichthärtbaren Zusammensetzung für Abdruck nach einem der Ansprüche 1 bis 8 auf einer Negativmusteroberfläche einer Form mit dem Negativmuster des feinen Musters auf der Oberfläche,
einen Schritt des Drückens eines Substrats gegen die lichthärtbare Zusammensetzung,
einen Schritt des Bestrahlens der lichthärtbaren Zusammensetzung mit Licht in so einem Zustand, dass das Substrat gegen die lichthärtbare Zusammensetzung gedrückt wird, um die lichthärtbare Zusammensetzung zu härten, um ein gehärtetes Produkt zu bilden, und
einen Schritt des Trennens der Form oder des Substrats und der Form von dem gehärteten Produkt, um ein geformtes Produkt mit einem feinen Muster auf seiner Oberfläche zu erhalten.

12. Verfahren zur Herstellung eines geformtes Produkts mit einem feinen Muster auf seiner Oberfläche nach Anspruch 9, das umfasst:
einen Schritt des miteinander Nahe- oder Inkontaktbringens eines Substrats und einer Form mit einem Negativmuster des feinen Musters auf ihrer Oberfläche, so dass das Negativmuster der Form auf der Substratseite ist,
einen Schritt des Füllens des Raums zwischen dem Substrat und der Form mit der lichthärtbaren Zusammensetzung für Abdruck nach einem der Ansprüche 1 bis 8,
einen Schritt des Bestrahlens der lichthärtbaren Zusammensetzung mit Licht in so einem Zustand, dass das Substrat und die Form nahe oder in Kontakt miteinander sind, um die lichthärtbare Zusammensetzung zu härten, um ein gehärtetes Produkt zu bilden, und
einen Schritt des Trennens der Form oder des Substrats und der Form von dem gehärteten Produkt, um ein geformtes Produkt mit einem feinen Muster auf seiner Oberfläche zu erhalten.

13. Verfahren zur Herstellung eines geformten Produkts mit einem feinen Muster auf seiner Oberfläche nach einem der Ansprüche 9 bis 12, wobei das geformte Produkt mit einem feinen Muster auf seiner Oberfläche eine Replikform für Abdruck ist.

14. Verfahren zur Herstellung eines geformten Produkts mit einem feinen Muster auf seiner Oberfläche nach einem der Ansprüche 9 bis 12, wobei das geformte Produkt mit einem feinen Muster auf seiner Oberfläche eine Replikform für Elektroformen ist.

## Revendications

1. Composition photodurcissable pour impression, contenant, en tant que composant principal, un composé comportant au moins un groupe acryloyloxy ou méthacryloyloxy, et comprenant en outre un polymère (D) qui est un copolymère du composé (A) suivant, du composé (B) suivant et du composé (C) suivant en une proportion de motifs du composé (A) de 20 à 45 % en masse, une proportion de motifs du composé (B) de 20 à 65 % en masse et une proportion de motifs du composé (C) de 5 à 40 % en masse, par rapport à la quantité totale des motifs du composé (A), des motifs du composé (B) et des motifs du composé (C), et qui présente une masse moléculaire moyenne en masse de 1 000 à 5 000 :
composé (A) : un composé représenté par la formule (1) suivante :
CH₂=C(R¹¹) -C(O)O-Q-R^{f} (1)
dans laquelle R¹¹ est un atome d'hydrogène ou un groupe méthyle, Q est une liaison simple ou un groupe de liaison divalent ne contenant pas d'atome de fluor, et R^{f} est un groupe polyfluoroalkyle dont la chaîne principale comporte 1 à 6 atome (s) de carbone, qui peut porter un atome d'oxygène d'éther entre les atomes de carbone ;
composé (B) : un composé représenté par la formule (2) suivante, présentant une masse moléculaire moyenne en nombre d'au plus 350 :
CH₂=C(R²¹)-C(O)O-(CH₂CH(R²²) O)ₙ-H (2)
dans laquelle R²¹ est un atome d'hydrogène ou un groupe méthyle, R²² est un atome d'hydrogène ou un groupe alkyle en C₁ à C₄, et n vaut de 3 à 6, étant entendu que les R²² dans une même molécule peuvent être identiques ou différents ;
composé (C) : un composé représenté par la formule (3) suivante :
CH₂=C(R³¹)-C(O)O-R³² (3)
dans laquelle R³¹ est un atome d'hydrogène ou un groupe méthyle, et R³² est un groupe hydrocarboné aliphatique monovalent en C₂ à C₁₅.

2. Composition photodurcissable selon la revendication 1, dans laquelle la proportion du polymère (D) dans la composition photodurcissable est de 0,01 à 5 % en masse par rapport à la composition photodurcissable.

3. Composition photodurcissable selon la revendication 1 ou 2, dans laquelle au moins une partie du composé comportant au moins un groupe acryloyloxy ou un groupe méthacryloyloxy est un composé comportant un seul groupe acryloyloxy ou méthacryloyloxy.

4. Composition photodurcissable selon la revendication 3, dans laquelle au moins une partie du composé comportant au moins un groupe acryloyloxy ou un groupe méthacryloyloxy est un composé (E) comportant des atomes de fluor, et la proportion du composé (E) dans la composition photodurcissable est de 5 à 40 % en masse par rapport à la composition photodurcissable.

5. Composition photodurcissable selon la revendication 3, dans laquelle au moins une partie du composé comportant au moins un groupe acryloyloxy ou un groupe méthacryloyloxy est un composé (F) ne comportant pas de fluor, et la proportion du composé (F) dans la composition photodurcissable est de 10 à 55 % en masse par rapport à la composition photodurcissable.

6. Composition photodurcissable selon la revendication 1 ou 2, dans laquelle au moins une partie du composé comportant au moins un groupe acryloyloxy ou un groupe méthacryloyloxy est un composé (H) comportant au moins deux groupes acryloyloxy ou groupes méthacryloyloxy, et la proportion du composé (H) dans la composition photodurcissable est de 10 à 75 % en masse par rapport à la composition photodurcissable.

7. Composition photodurcissable selon l'une quelconque des revendications 1 à 6, qui contient un amorceur de polymérisation (G) en une quantité de 1 à 12 % en masse par rapport à la composition photodurcissable.

8. Composition photodurcissable selon l'une quelconque des revendications 1 à 7, qui présente une viscosité à 25°C de 3 à 200 mPa.s.

9. Procédé pour produire un produit moulé doté d'un motif fin sur sa surface, qui comprend :
une étape consistant à porter la composition photodurcissable pour impression telle que définie dans l'une quelconque des revendications 1 à 8 en contact avec une surface à motif inversé d'un moule doté du motif inversé dudit motif fin sur ladite surface,
une étape consistant à irradier la composition photodurcissable avec une lumière dans un état tel que la composition photodurcissable soit en contact avec la surface du moule, pour durcir la composition photodurcissable afin de former un produit durci, et
une étape consistant à séparer le moule du produit durci pour obtenir un produit moulé doté d'un motif fin sur sa surface.

10. Procédé pour produire un produit moulé doté d'un motif fin sur sa surface selon la revendication 9, qui comprend :
une étape consistant à placer la composition photodurcissable pour impression telle que définie dans l'une quelconque des revendications 1 à 8 sur une surface d'un substrat,
une étape consistant à presser un moule doté d'un motif inversé dudit motif fin sur sa surface contre la composition photodurcissable de sorte que le motif inversé du moule soit en contact avec la composition photodurcissable,
une étape consistant à irradier la composition photodurcissable avec une lumière dans un état tel que le moule soit pressé contre la composition photodurcissable, pour durcir la composition photodurcissable afin de former un produit durci, et
une étape consistant à séparer le moule, ou le substrat et le moule, du produit durci pour obtenir un produit moulé doté d'un motif fin sur sa surface.

11. Procédé pour produire un produit moulé doté d'un motif fin sur sa surface selon la revendication 9, qui comprend :
une étape consistant à placer la composition photodurcissable pour impression telle que définie dans l'une quelconque des revendications 1 à 8 sur une surface à motif inversé d'un moule doté du motif inversé dudit motif fin sur ladite surface,
une étape consistant à presser un substrat contre la composition photodurcissable,
une étape consistant à irradier la composition photodurcissable avec une lumière dans un état tel que le substrat soit pressé contre la composition photodurcissable, pour durcir la composition photodurcissable afin de former un produit durci, et
une étape consistant à séparer le moule, ou le substrat et le moule, du produit durci pour obtenir un produit moulé doté d'un motif fin sur sa surface.

12. Procédé pour produire un produit moulé doté d'un motif fin sur sa surface selon la revendication 9, qui comprend :
une étape consistant à porter un substrat et un moule doté d'un motif inversé dudit motif fin sur sa surface à proximité ou en contact mutuel de sorte que le motif inversé du moule soit du côté substrat,
une étape consistant à remplir l'espace entre le substrat et le moule avec la composition photodurcissable pour impression telle que définie dans l'une quelconque des revendications 1 à 8,
une étape consistant à irradier la composition photodurcissable avec une lumière dans un état tel que le substrat et le moule soient à proximité ou en contact mutuel, pour durcir la composition photodurcissable afin de former un produit durci, et
une étape consistant à séparer le moule, ou le substrat et le moule, du produit durci pour obtenir un produit moulé doté d'un motif fin sur sa surface.

13. Procédé pour produire un produit moulé doté d'un motif fin sur sa surface selon l'une quelconque des revendications 9 à 12, dans lequel le produit moulé doté d'un motif fin sur sa surface est un moule d'empreinte pour impression.

14. Procédé pour produire un produit moulé doté d'un motif fin sur sa surface selon l'une quelconque des revendications 9 à 12, dans lequel le produit moulé doté d'un motif fin sur sa surface est un moule d'empreinte pour électroformage.
